(19) Europäisches Patentamt
European Patent Office
Office européen des brevets

(11) EP 4 145 546 B1

(12) **EUROPEAN PATENT SPECIFICATION**

(45) Date of publication and mention of the grant of the patent:
**29.01.2025 Bulletin 2025/05**

(21) Application number: **21853303.2**

(22) Date of filing: **27.07.2021**

(51) International Patent Classification (IPC):
***H10K 85/10*** *(2023.01)* ***H10K 85/30*** *(2023.01)*
***H10K 85/60*** *(2023.01)* *H10K 50/17* *(2023.01)*

(52) Cooperative Patent Classification (CPC):
**H10K 85/151; H10K 85/111; H10K 85/322; H10K 85/658;** H10K 50/155; Y02E 10/549

(86) International application number:
**PCT/KR2021/009734**

(87) International publication number:
**WO 2022/030858 (10.02.2022 Gazette 2022/06)**

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2020 KR 20200098674**

(43) Date of publication of application:
**08.03.2023 Bulletin 2023/10**

(73) Proprietor: **LG Chem, Ltd.**
**Seoul 07336 (KR)**

(72) Inventors:
- **KIM, Juhwan**
  **Daejeon 34122 (KR)**
- **LEE, Jaechol**
  **Daejeon 34122 (KR)**
- **JUNG, Sejin**
  **Daejeon 34122 (KR)**
- **KIM, Ji Hoon**
  **Daejeon 34122 (KR)**
- **KHIM, Dongyoon**
  **Daejeon 34122 (KR)**
- **BAE, Jaesoon**
  **Daejeon 34122 (KR)**
- **LEE, Jiyoung**
  **Daejeon 34122 (KR)**
- **LEE, Ho Gyu**
  **Daejeon 34122 (KR)**
- **SEO, Seog Jae**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**EP-A1- 3 514 140**
**EP-A1- 3 675 194**
**WO-A1-2019/066338**
**WO-A1-2020/111603**
**WO-A2-2011/159876**
**KR-A- 20180 059 380**
**US-A1- 2013 087 779**
**US-A1- 2015 340 629**
**US-A1- 2020 212 306**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### [TECHNICAL FIELD]

CROSS-REFERENCE TO RELATED APPLICATION(S)

This application claims the benefit of Korean Patent Application No. 10-2020-0098674 filed on August 6, 2020 and Korean Patent Application No. 10-2021-0098389 filed on July 27, 2021 in the Korean Intellectual Property Office.
The present disclosure relates to an organic light emitting device.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.
The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.
WO 2020/111603 A1, WO 2019/066338 A1 and WO 2011/159876 A2 describe organic light emitting devices having hole transport layers formed using certain kinds of polymers.
There is a continuous need to develop new materials for organic materials used in the organic light emitting device as described above.
Meanwhile, recently, in order to reduce process costs, an organic light emitting device using a solution process, particularly an inkjet process, has been developed instead of a conventional deposition process. In the initial stage of development, attempts have been made to develop organic light emitting devices by coating all organic light emitting device layers by a solution process, but current technology has limitations. Therefore, only HIL, HTL, and EML are processed by a solution process, and a hybrid process utilizing traditional deposition processes is being studied as a subsequent process.
Therefore, the present disclosure provides a novel material for an organic light emitting device that can be used for an organic light emitting device and at the same time, can be used for a solution process, and an organic light emitting device comprising the same.

[Prior Art Literature]

[Patent Literature]

(Patent Literature 1) Korean Patent Publication No. 10-2000-0051826

### [DETAILED DESCRIPTION OF THE INVENTION]

### [Technical Problem]

It is an object of the present disclosure to provide an organic light emitting device.

### [Technical Solution]

In order to achieve the above object, according to the present disclosure, there is provided an organic light emitting device comprising: an anode, a cathode, a light emitting layer between the anode and the cathode, and a hole transport layer between the anode and the light emitting layer, wherein said hole transport layer may be a hole injection layer, a hole transport layer, or a layer that simultaneously injects and transports holes; and wherein the hole transport layer comprises a polymer containing a repeating unit represented by the following Chemical Formula 1, and an ionic compound containing an anionic group represented by the following Chemical Formula 2:

[Chemical Formula 1]

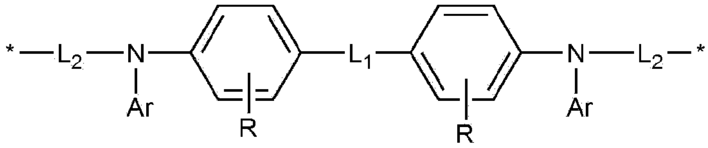

wherein in Chemical Formula 1,
$L_1$ is a substituted or unsubstituted $C_{6-60}$ arylene,
each $L_2$ is independently a substituted or unsubstituted $C_{6-60}$ arylene,
each Ar is independently a substituted or unsubstituted $C_{6-60}$ aryl,
each R is independently hydrogen, deuterium, or a substituted or unsubstituted $C_{1-10}$ alkyl,

[Chemical Formula 2]

$$(Ar''_1)_{n1}-\overset{\ominus}{B}-(Ar''_2)_{n2}$$

wherein in Chemical Formula 2,
n1 and n2 are each independently an integer of 1 to 3, with the proviso that n1+n2 is 4,
$Ar''_1$ is

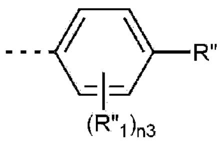,

R" is a photocurable group; or a thermosetting group,
each $R''_1$ is independently hydrogen, halogen, or a $C_{1-60}$ haloalkyl, n3 is an integer of 1 to 4,

$Ar''_2$is

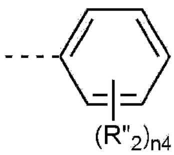,

each $R''_2$ is independently hydrogen, halogen, a $C_{1-60}$ haloalkyl, a photocurable group, or a thermosetting group, and
n4 is an integer of 1 to 5;

wherein the polymer further comprises a repeating unit selected from the group consisting of the following:

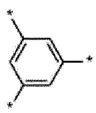
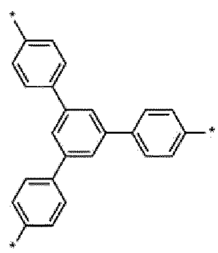
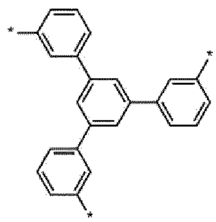

## [ADVANTAGEOUS EFFECTS]

The organic light emitting device according to the present disclosure can prepare a hole transport layer by a solution process, and can improve the efficiency, achieve low driving voltage and/or improve lifetime characteristics in the organic light emitting device.

## [BRIEF DESCRIPTION OF THE DRAWINGS]

Fig. 1 shows an example of an organic light emitting device comprising a substrate 1, an anode 2, a hole transport layer 3, a light emitting layer 4, and a cathode 5.

Fig. 2 shows an example of an organic light emitting device comprising a substrate 1, an anode 2, a hole transport layer 3, a light emitting layer 4, an electron transport layer 6, an electron injection layer 7 and a cathode 5.

## [DETAILED DESCRIPTION OF THE EMBODIMENTS]

Hereinafter, embodiments of the present disclosure will be described in more detail to assist in the understanding of the invention.

As used herein, the notation

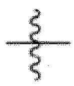 or 

means a bond linked to another substituent group.

As used herein, the term "substituted or unsubstituted" means being unsubstituted or substituted with one or more substituents selected from the group consisting of deuterium; a halogen group; a cyano group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; or a heteroaryl containing at least one of N, O and S atoms, or being unsubstituted or substituted with a substituent to which two or more substituents of the above-exemplified substituents are connected. For example, "a substituent in which two or more substituents are connected" may be a biphenyl group. Namely, a biphenyl group may be an aryl group, or it may also be interpreted as a substituent in which two phenyl groups are connected.

In the present disclosure, the carbon number of a carbonyl group is not particularly limited, but is preferably 1 to 40. Specifically, the carbonyl group may be a compound having the following structural formulae.

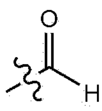 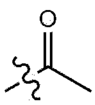 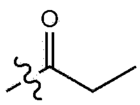 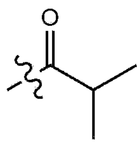

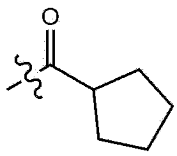 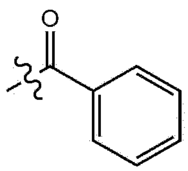 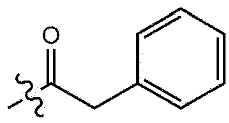

In the present disclosure, an ester group may have a structure in which oxygen of the ester group may be substituted by a straight-chain, branched, or cyclic alkyl group having 1 to 25 carbon atoms, or an aryl group having 6 to 25 carbon atoms. Specifically, the ester group may be a compound having the following structural formulae.

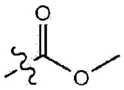
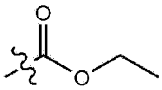
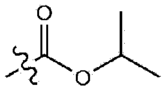
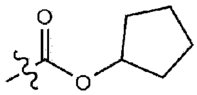
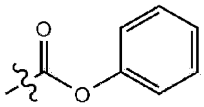

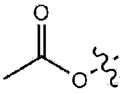
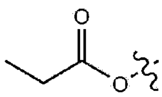
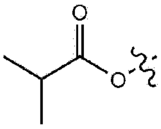
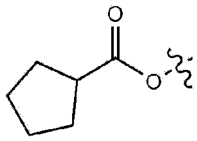
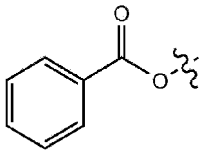

In the present disclosure, the carbon number of an imide group is not particularly limited, but is preferably 1 to 25. Specifically, the imide group may be a compound having the following structural formulae.

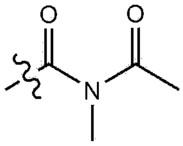
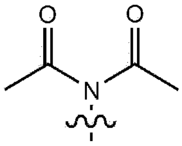
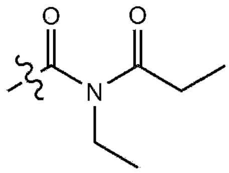

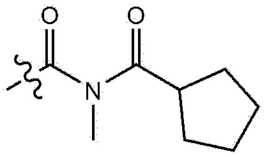
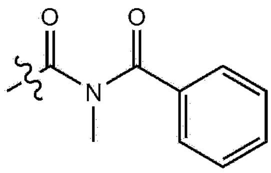

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, and a phenylsilyl group.

In the present disclosure, a boron group specifically includes a trimethylboron group, a triethylboron group, a t-butyldimethylboron group, a triphenylboron group, and a phenylboron group.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohectylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, and 5-methylhexyl.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl) vinyl-1-yl, a stilbenyl group, and a styrenyl group.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl.

In the present disclosure, an aryl group is not particularly limited, but the carbon number thereof is preferably 6 to 60, and it may be a monocyclic aryl group or a polycyclic aryl group. According to one embodiment, the carbon number of

the aryl group is 6 to 30. According to one embodiment, the carbon number of the aryl group is 6 to 20. The aryl group may be a phenyl group, a biphenyl group, or a terphenyl group. The polycyclic aryl group includes a naphthyl group, an anthracenyl group, a phenanthrenyl group, a pyrenyl group, a perylenyl group, a chrysenyl group, and a fluorenyl group.

In the present disclosure, the fluorenyl group may be substituted, and two substituents may be linked with each other to form a spiro structure. **In** the case where the fluorenyl group is substituted,

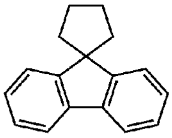 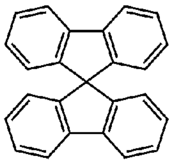 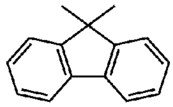 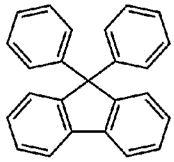 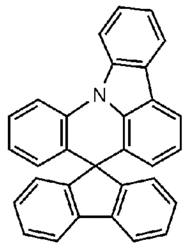

can be formed.

In the present disclosure, a heteroaryl is a heteroaryl containing one or more of O, N, Si and S as a heteroatom, and the carbon number thereof is not particularly limited, but is preferably 2 to 60. Examples of the heteroaryl include xanthene, thioxanthen, a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, and a dibenzofuranyl group.

In the present disclosure, the aryl group in the aralkyl group, the aralkenyl group, the alkylaryl group, the arylamine group and the arylsily group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heteroaryl. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heteroaryl group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heteroaryl can be applied, except that the heterocyclic group is not a monovalent group but formed by combining two substituent groups.

**(Anode and Cathode)**

An organic light emitting device according to the present disclosure includes an anode and a cathode.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or $SnO_2$:Sb; conductive compounds such as poly(3-methylthiophene), poly[3,4-(ethylene-1,2-dioxy)thiophene](PEDOT), polypyrrole, and polyaniline.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or $LiO_2$/Al.

**(Hole Transport Layer)**

The organic light emitting device according to the present disclosure includes a hole transport layer between the anode and the light emitting layer, wherein the hole transport layer includes a polymer containing a repeating unit represented by Chemical Formula 1, and an ionic compound containing an anionic group represented by Chemical Formula 2. The hole transport layer may be a hole injection layer, a hole transport layer, or a layer that simultaneously

injects and transports holes.

Preferably, within the hole transport layer, the weight ratio of the polymer and the ionic compound is 99:1 to 50:50, 95:5 to 60:40, or 90:10 to 70:30.

Hereinafter, each material will be described in detail.

**(Polymer containing a repeating unit represented by Chemical Formula 1)**

In Chemical Formula 1, preferably, $L_1$ is phenylene, biphenyldiyl, or binaphthyldiyl, with the $L_1$ being unsubstituted or substituted with one or two $C_{1-10}$ alkyl, or one or more deuterium.

Preferably, $L_1$ is represented by any one of the following:

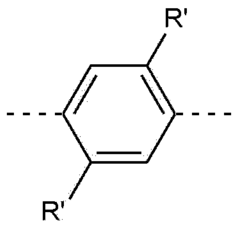

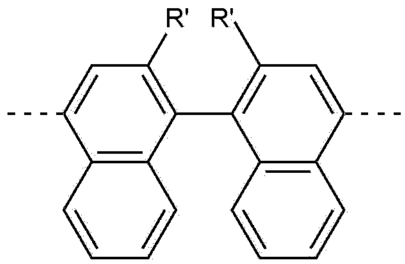

wherein, each R' is independently a $C_{1-10}$ alkyl.

Preferably, each R' is independently methyl, propyl, butyl, pentyl, or hexyl.

Each $L_2$ is independently phenylene, or biphenyldiyl, with the $L_2$ being unsubstituted or substituted with one or more deuterium. More preferably, each $L_2$ is independently 1,4-phenylene, or 4,4-biphenyldiyl, with the $L_2$ being unsubstituted or substituted with one or more deuterium. Preferably, $L_2$ is identical to each other.

Preferably, each Ar is independently phenyl, or biphenylyl, with the Ar being unsubstituted or substituted with a $C_{1-10}$ alkyl, a $N(C_{6-60}\ aryl)_2$, or one or more deuterium. More preferably, Ar is biphenylyl, with the Ar being unsubstituted or substituted with propyl, isopropyl, butyl, isobutyl, $N(phenyl)_2$, or one or more deuterium. Preferably, Ar is identical to each other.

Preferably, each R is independently hydrogen, deuterium, or methyl.

Preferably, the Chemical Formula 1 is represented by any one selected from the group consisting of the following:

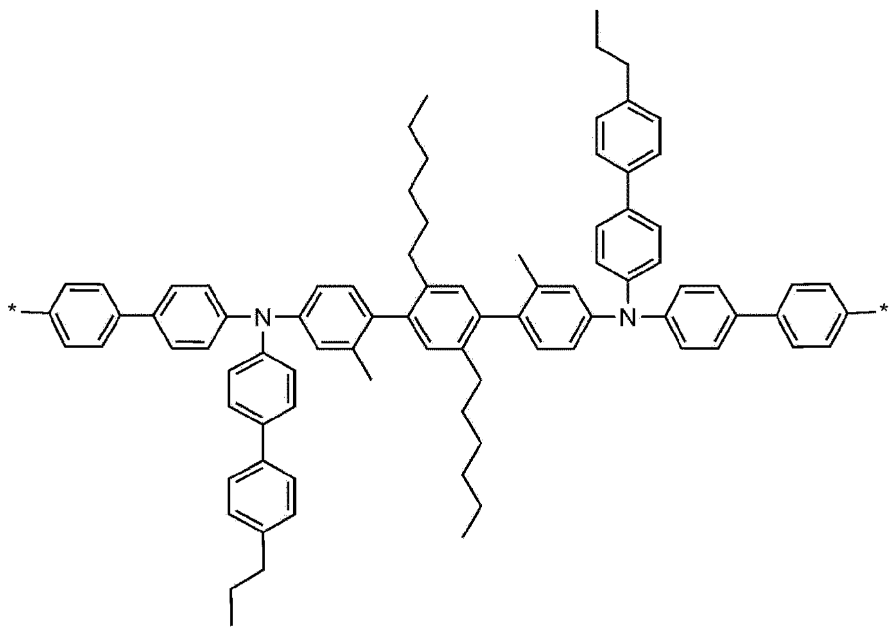

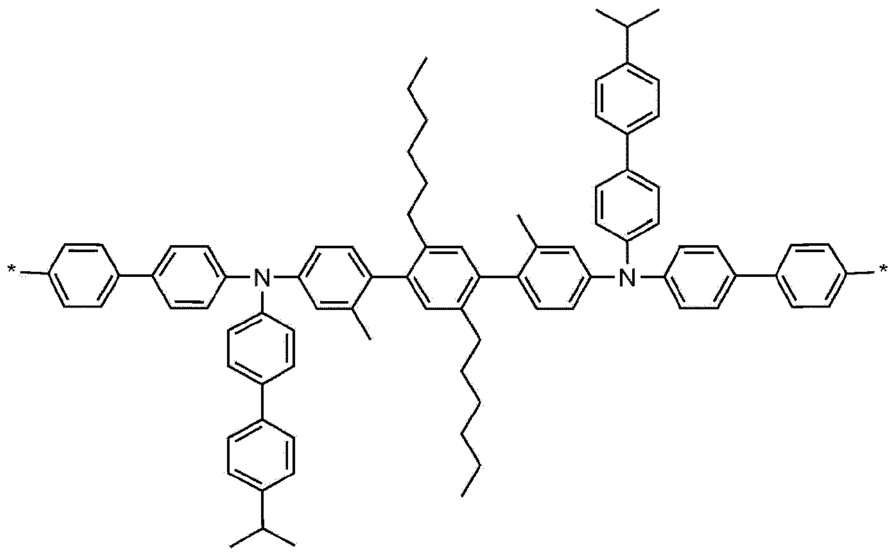

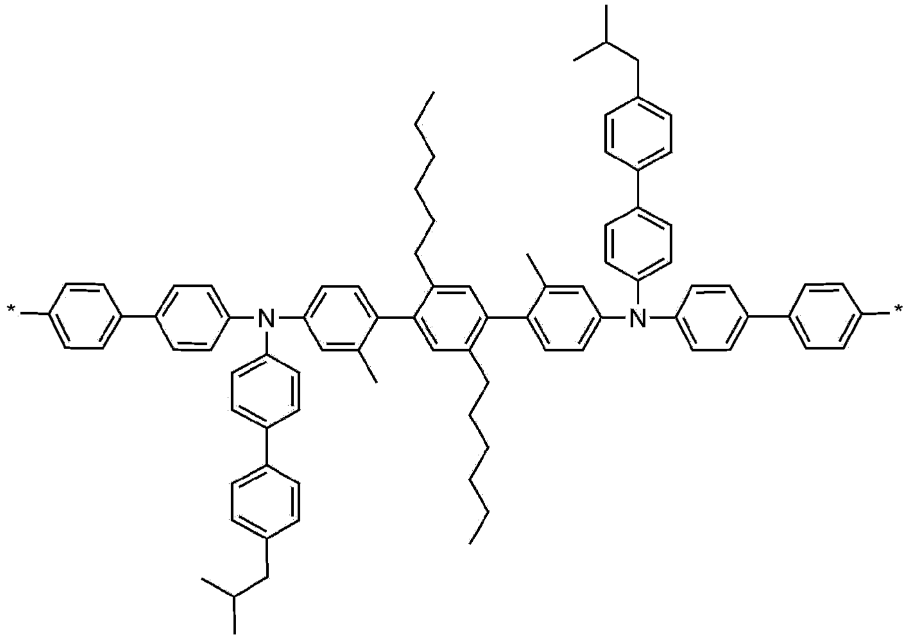

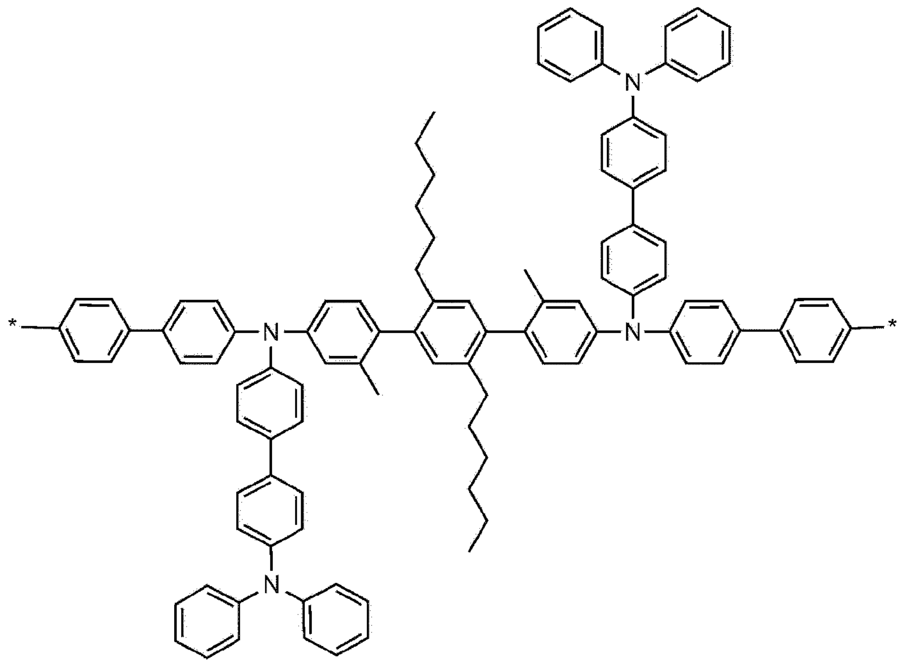

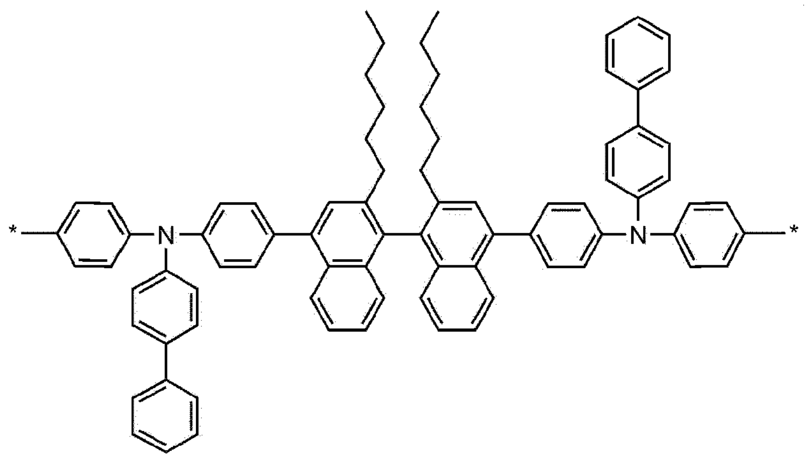

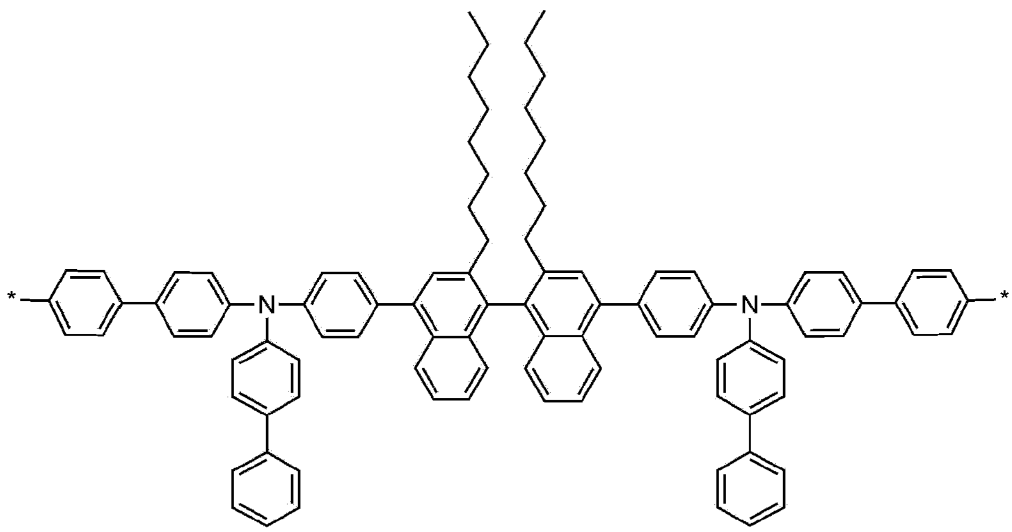

In addition, the repeating unit represented by Chemical Formula 1 is derived from the compound represented by the following Chemical Formula 1-1:

[Chemical Formula 1-1]

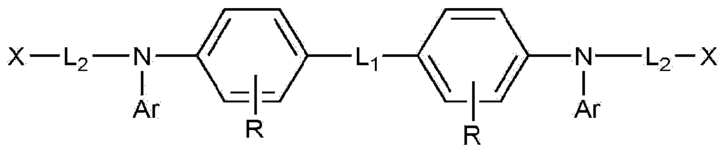

wherein in Chemical Formula 1-1, the definition of the remaining substituents except for X are the same as defined above, and X is halogen, more preferably chloro or bromo.

The compound represented by Chemical Formula 1-1 can be prepared by the method as shown in the following Reaction Scheme 1.

[Reaction Scheme 1]

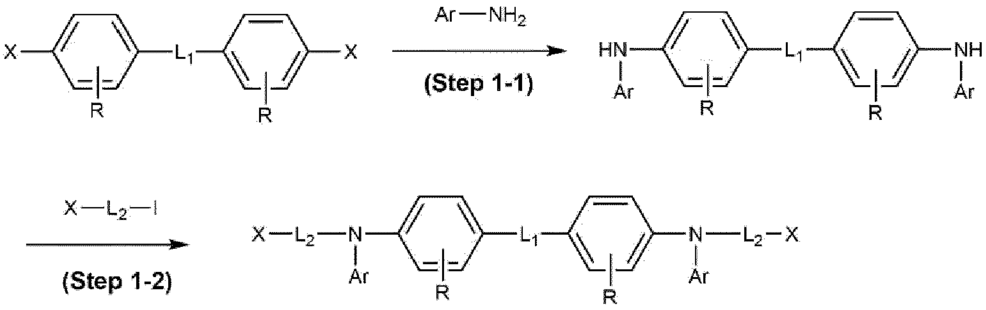


**1-1**

wherein in Reaction Scheme 1, the definition of the remaining substituents except for X are the same as defined above, and X is halogen, more preferably chloro or bromo.

Step 1-1 and step 1-2 in the Reaction Scheme 1 are an amine substitution reaction, respectively, which is preferably carried out in the presence of a palladium catalyst and a base, and a reactive group for the amine substitution reaction can be modified as known in the art. **The** above preparation method may be further embodied in Preparation Examples described hereinafter.

The polymer further contains a repeating unit represented by the following Chemical Formula 1':

[Chemical Formula 1']

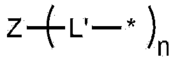

wherein in Chemical Formula 1',
each L' is independently a single bond; or a substituted or unsubstituted $C_{6-60}$ arylene,
Z is C, Si, N, Si(phenyl), or an n-valent substituted or unsubstituted $C_{6-60}$ aromatic ring,
n is 3 or 4, with the proviso that if Z is C or Si, n is 4, and if Z is N or Si(phenyl), n is 3, and
* indicates the attachment point within the polymer, wherein the repeating unit of Chemical Formula 1 'is any one selected from the following:

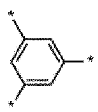

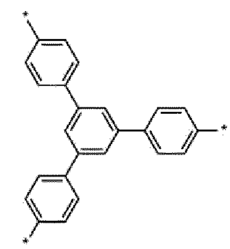

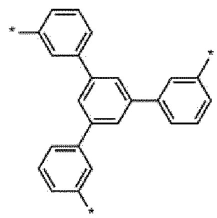.

The repeating unit represented by Chemical Formula 1' is a branched repeating unit, and as it is contained in the polymer structure according to the present disclosure, it can improve the solubility in a solvent by making the polymer structure into a branched structure.

The polymer may further include a repeating unit represented by the following Chemical Formula 1":

[Chemical Formula 1"] Ar"-*

wherein in Chemical Formula 1",
Ar" is a substituted or unsubstituted $C_{6-60}$ aryl, and
* indicates the attachment point within the polymer.

The terminal group represented by Chemical Formula 1" is an aromatic cyclic terminal group, and when it is contained in the polymer structure according to the present disclosure, it can improve the solubility in a solvent.
Preferably, Ar" is phenyl, or biphenylyl, with the Ar" being unsubstituted or substituted with a $C_{1-10}$ alkyl, a photocurable group, or a thermosetting group.
Preferably, the Chemical Formula 1" is any one selected from the group consisting of the following:

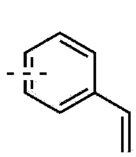
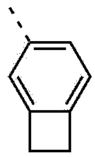
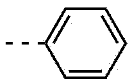
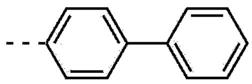

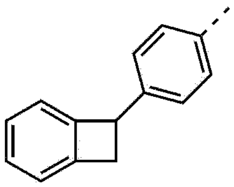
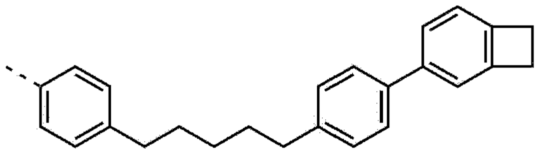

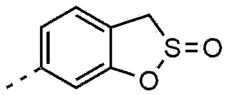
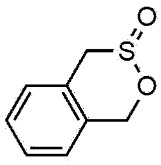

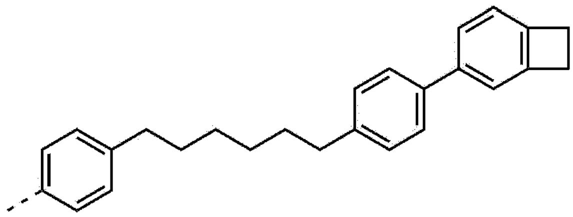

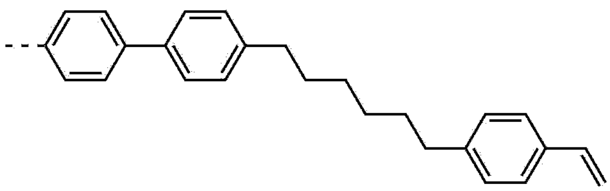

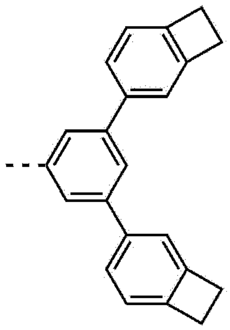

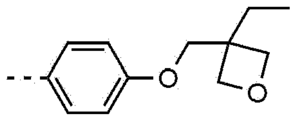

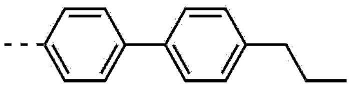

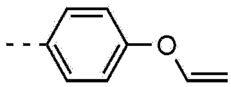

In addition, the repeating unit represented by Chemical Formula 1" is derived from a compound represented by the following Chemical Formula 1"-1.

[Chemical Formula 1"-1] Ar"-X"

wherein in Chemical Formula 1"-1, the definition of the remaining substituents except for X" are the same as defined above, and X" is halogen, more preferably chloro or bromo.

The polymer according to the present disclosure can be prepared by polymerizing the monomer represented by Chemical Formula 1-1. Further, the polymer according to the present disclosure can be prepared by polymerizing the above-mentioned monomer represented by Chemical Formula 1-1 and the above-mentioned monomer represented by Chemical Formula 1'-1. Further, the polymer according to the present disclosure can be prepared by polymerizing the monomer represented by Chemical Formula 1-1, the monomer represented by Chemical Formula 1'-1, and the monomer represented by Chemical Formula 1"-1. Preferably, the polymer according to the present disclosure is a random copolymer containing the repeating unit.

In the polymer according to the present disclosure, the repeating unit of Chemical Formula 1' is preferably contained in an amount of 10 to 50 moles relative to 100 moles of the repeating unit represented by Chemical Formula 1. More preferably, the repeating unit of Chemical Formula 1' is contained in an amount of 15 moles or more, 20 moles or more, 25 moles or more, or 30 moles or more; and 45 moles or less, 40 moles or less, or 35 moles or less, relative to 100 moles of the repeating unit represented by Chemical Formula 1.

In the polymer according to the present disclosure, when the repeating unit of Chemical Formula 1" is contained, the repeating unit of Chemical Formula 1" is preferably contained in an amount of 20 to 65 moles relative to 100 moles of the repeating unit represented by Chemical Formula 1. More preferably, the repeating unit of Chemical Formula 1" is contained in an amount of 25 moles or more, 30 moles or more, 35 moles or more, or 40 moles or more; and 60 moles or less, or 55 moles or less relative to 100 moles of the repeating unit represented by Chemical Formula 1.

In addition, the reaction molar ratio of the monomer represented by Chemical Formula 1-1, the monomer represented by Chemical Formula 1'-1, and/or the monomer represented by Chemical Formula 1"-1 can be adjusted, thereby adjusting the molar ratio of the polymer.

Preferably, the weight average molecular weight (Mw; g / mol) of the polymer is 3,000 to 1,000,000, more preferably 10,000 or more, 20,000 or more, 30,000 or more, 40,000 or more, 50,000 or more, 60,000 or more, 70,000 or more, or 80,000 or more; and 500,000 or less, 400,000 or less, 300,000 or less, 200,000 or less, or 150,000 or less.

Preferably, the polydispersity index (PDI; Mw/Mn) of the polymer is 1 to 10, more preferably 1.5 or more, 2.0 or more, 2.1 or more, 2.2 or more, 2.3 or more, 2.4 or more, or 2.5 or more; and 9.0 or less, 8.0 or less, 7.0 or less, 6.0 or less, or 5.0 or less.

**(Anionic group represented by Chemical Formula 2)**

In Chemical Formula 2, preferably, for the photocurable group; or the thermosetting group of R", the content of R defined in Chemical Formula 1 can be applied.

Preferably, each $R''_1$ is independently hydrogen, fluoro, or $CF_3$.

Preferably, $Ar''_1$ is any one selected from the group consisting of the following:

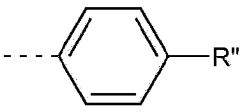
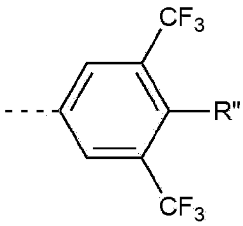
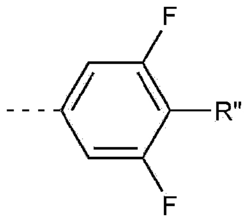
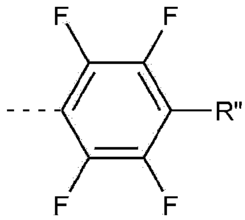

Preferably, each R"$_1$ is independently hydrogen, fluoro, $CF_3$, $CF(CF_3)_2$, $CF_2CF_2CF_2CF_3$, a photocurable group, or a thermosetting group. At this time, for the photocurable group or the thermosetting group, the content of R defined in Chemical Formula 1 can be applied.

Preferably, Ar"2 is any one selected from the group consisting of the following:

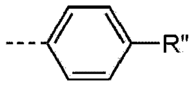
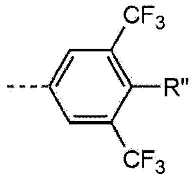
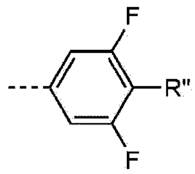
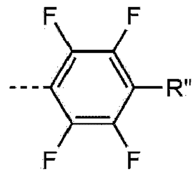
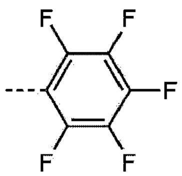
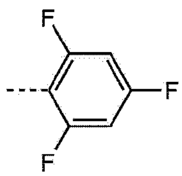
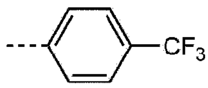
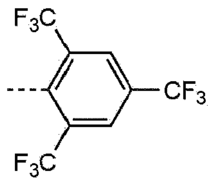
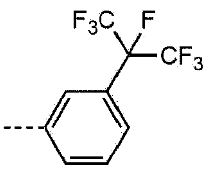
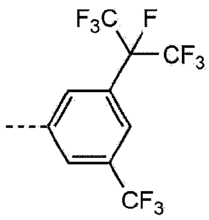
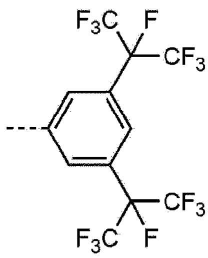
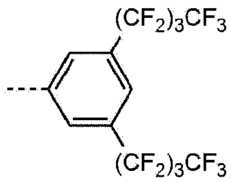
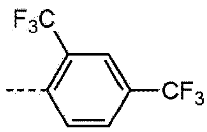
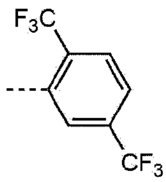

Representative examples of the anionic group represented by Chemical Formula 2 is as follows:

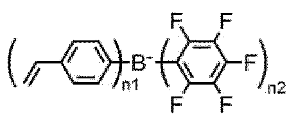
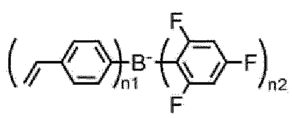
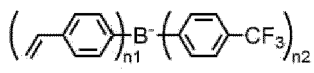
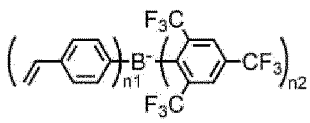
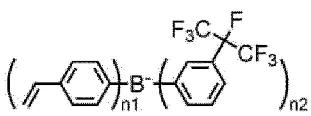
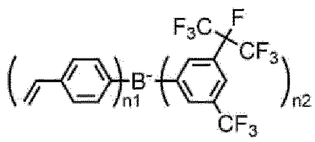

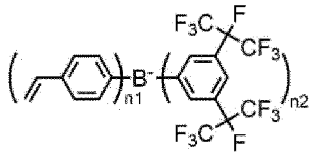

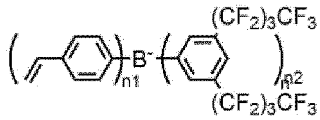

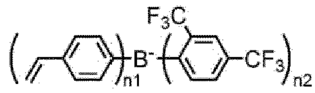

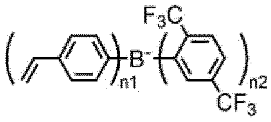

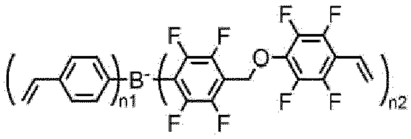

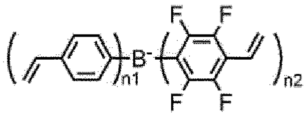

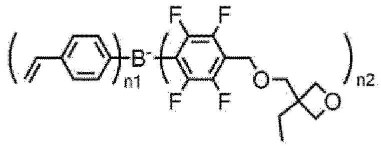

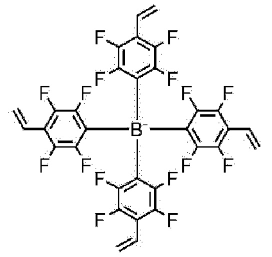

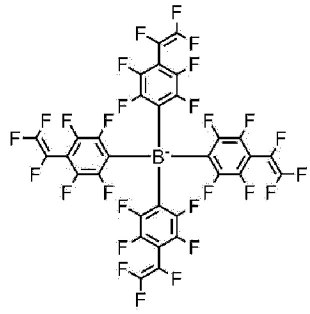

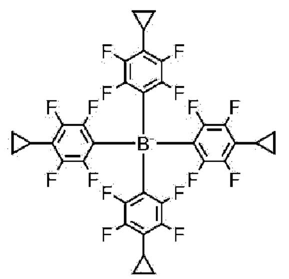

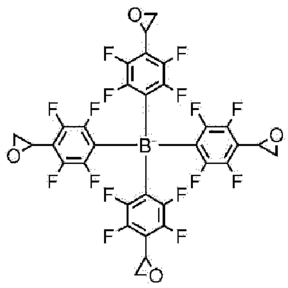

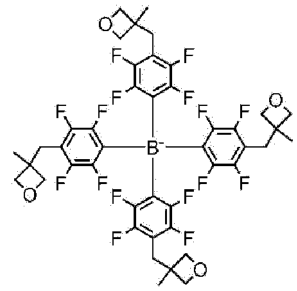

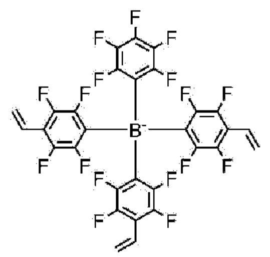

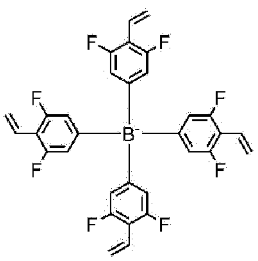

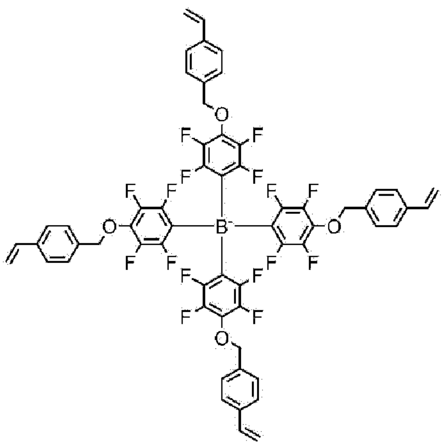

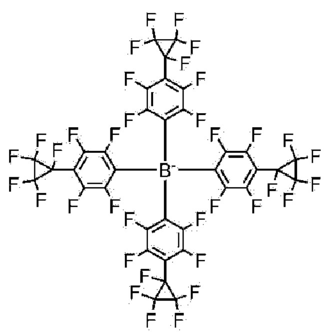

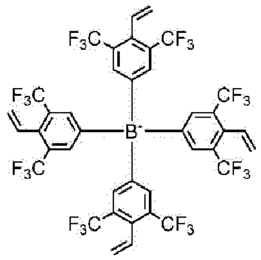

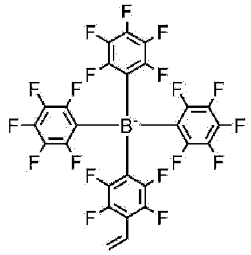

**(Cationic group)**

In addition, the ionic compound according to the present disclosure may further include a cationic group.

Preferably, the cationic group is selected from a monovalent cationic group, an onium compound or the following structural formulas:

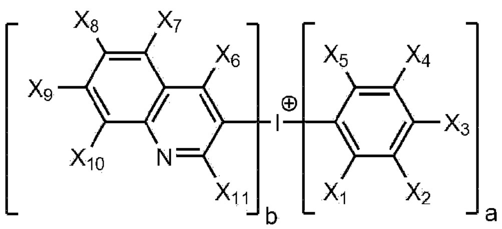

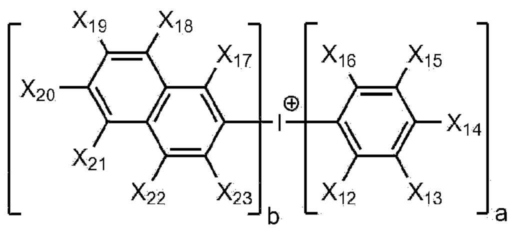

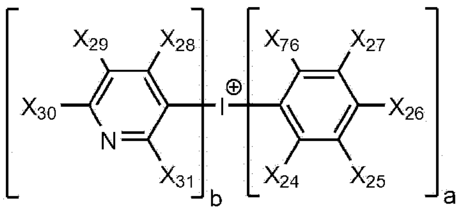

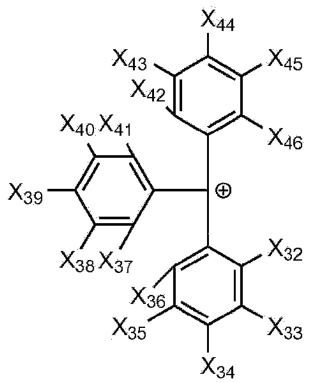

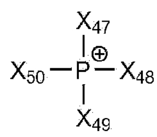

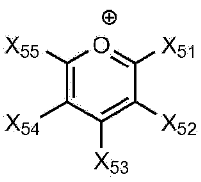

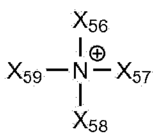

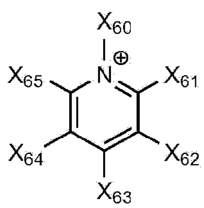

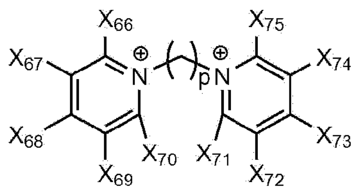

wherein,

> $X_1$ to $X_{76}$ are each independently hydrogen; cyano; nitro; halogen; - $COOR_{104}$; a substituted or unsubstituted $C_{1-60}$ alkyl; a substituted or unsubstituted $C_{1-60}$ alkoxy; a substituted or unsubstituted $C_{3-60}$ cycloalkyl; a substituted or unsubstituted $C_{1-60}$ fluoroalkyl; or a substituted or unsubstituted $C_{6-60}$ aryl; or a curable group,
> $R_{104}$ is hydrogen; deuterium; or a substituted or unsubstituted $C_{1-60}$ alkyl,
> p is an integer of 0 to 10,
> a is 1 or 2, b is 0 or 1, and a+b=2.

Preferably, the cationic group is selected from the group consisting of the following Chemical Formulas:

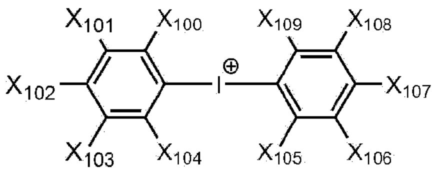
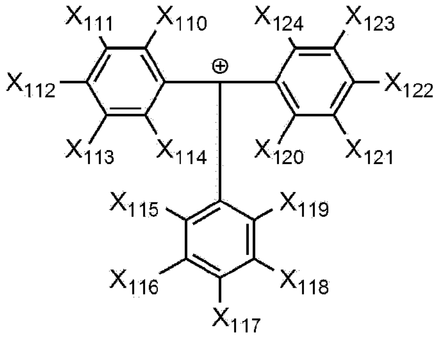

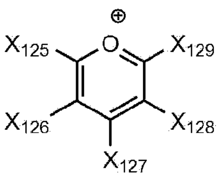
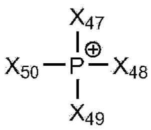
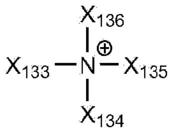
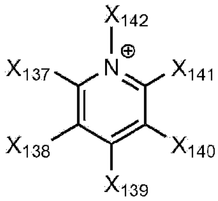

wherein, $X_{47}$ to $X_{50}$, $X_{100}$ to $X_{129}$ and $X_{133}$ to $X_{142}$ are $X_1$ to $X_{76}$ are each independently hydrogen; cyano; nitro; halogen; $-COOR_{104}$; a substituted or unsubstituted $C_{1-60}$ alkyl; a substituted or unsubstituted $C_{1-60}$ alkoxy; a substituted or unsubstituted $C_{3-60}$ cycloalkyl; a substituted or unsubstituted $C_{1-60}$ fluoroalkyl; or a substituted or unsubstituted $C_{6-60}$ aryl; or a curable group, and

$R_{104}$ is a substituted or unsubstituted alkyl group.

Representative examples of the cationic group are as follows:

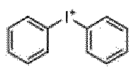 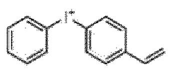 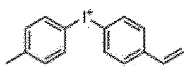 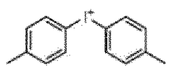 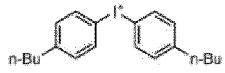

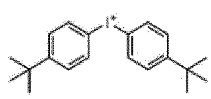 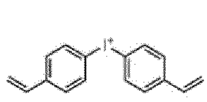 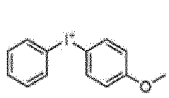 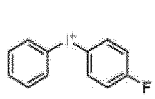 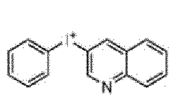

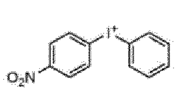 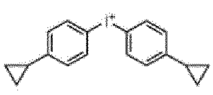 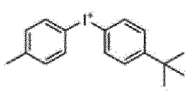 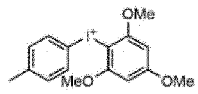 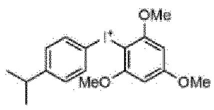

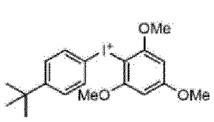 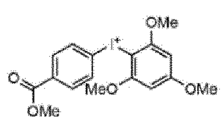 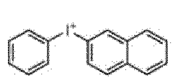 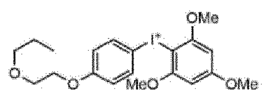 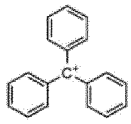

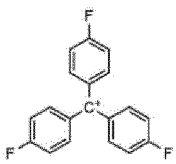 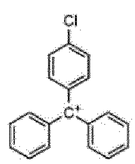 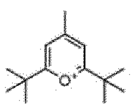 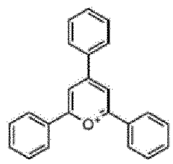 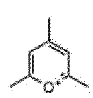

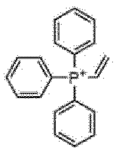 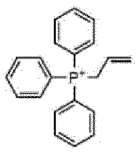 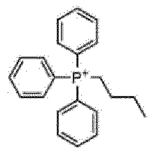 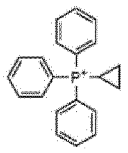 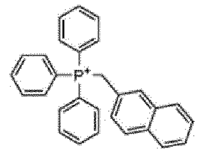

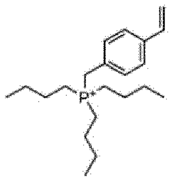 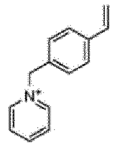 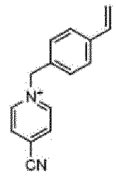 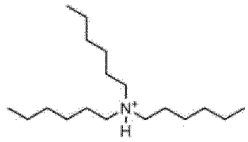 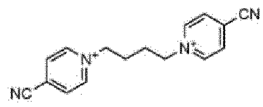

Meanwhile, a method of forming the hole transport layer according to the present disclosure will be described below.

**(Light Emitting Layer)**

The light emitting layer may include a host material and a dopant material. The host material may be a fused aromatic ring derivative, a heterocycle-containing compound or the like. Specific examples of the fused aromatic ring derivatives include anthracene derivatives, pyrene derivatives, naphthalene derivatives, pentacene derivatives, phenanthrene compounds, fluoranthene compounds, and the like. Examples of the heterocyclic-containing compounds include carbazole derivatives, dibenzofuran derivatives, ladder-type furan compounds, and pyrimidine derivatives.

Examples of the dopant material include an aromatic amine derivative, a styrylamine compound, a boron complex, a fluoranthene compound, a metal complex, and the like. Specifically, the aromatic amine derivative is a substituted or unsubstituted fused aromatic ring derivative having an arylamino group, and examples thereof include pyrene, anthracene, chrysene, periflanthene and the like, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, and styryltetramine. Further, the metal complex includes an iridium complex, and a platinum complex.

**(Electron Transport Layer)**

The organic light emitting device according to the present disclosure may include an electron transport layer on the light emitting layer.

The electron transport layer is a layer that receives electrons from an electron injection layer and transports the electrons up to the light emitting layer, and an electron transport material is suitably a material which may receive electrons well from a cathode and transfer the electrons to a light emitting layer, and has a large mobility for electrons. Specific examples thereof include: an Al complex of 8-hydroxyquinoline; a complex including $Alq_3$; an organic radical compound; and a hydroxyflavone-metal complex. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

**(Electron Injection Layer)**

The organic light emitting device according to the present disclosure may include an electron injection layer between the electron transport layer (or the light emitting layer) and the cathode, if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, and a nitrogen-containing 5-membered ring derivative.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, and bis(2-methyl-8-quinolinato)(2-naphtholato) gallium.

In addition to the above-mentioned materials, the light emitting layer, the hole injection layer, the hole transport

layer, the electron transport layer, and the electron injection layer may further include an inorganic compound such as a quantum dot or a polymer compound such as quantum dot.

The quantum dot may be, for example, a colloidal quantum dot, an alloy quantum dot, a core/shell quantum dot, or a core quantum dot. It may be a quantum dot including an element belonging to Groups 2 and 16, an element belonging to Groups 13 and 15, an element belonging to Groups 13 and 17, an element belonging to Groups 11 and 17, an element belonging to Groups 14 and 15. Quantum dots containing elements such as Cadmium(Cd), selenium(Se), zinc(Zn), sulfur(S), phosphorus(P), indium(In), tellurium(Te), lead(Pb), gallium(Ga), arsenic(As), etc. can be used.

**(Organic Light Emitting Device)**

The organic light emitting device according to the present disclosure may be a normal type organic light emitting device in which an anode, one or more organic material layers and a cathode are sequentially stacked on a substrate. Further, the organic light emitting device according to the present disclosure may be an inverted type organic light emitting device in which a cathode, one or more organic material layers and an anode are sequentially stacked on a substrate. For example, the structure of an organic light emitting device according to an embodiment of the present disclosure is illustrated in Figs. 1 and 2.

Fig. 1 shows an example of an organic light emitting device comprising a substrate 1, an anode 2, a hole transport layer 3, a light emitting layer 4, and a cathode 5. In such a structure, the hole transport layer includes a polymer containing a repeating unit represented by Chemical Formula 1, and an anionic compound represented by Chemical Formula 2.

Fig. 2 shows an example of an organic light emitting device comprising a substrate 1, an anode 2, a hole transport layer 3, a light emitting layer 4, an electron transport layer 6, an electron injection layer 7 and a cathode 5. In such a structure, the hole transport layer includes a polymer containing a repeating unit represented by Chemical Formula 1, and an anionic compound represented by Chemical Formula 2.

The organic light emitting device according to the present disclosure can be manufactured by materials and methods known in the art, except that the above-mentioned materials are used.

For example, the organic light emitting device according to the present disclosure can be manufactured by sequentially stacking an anode, an organic material layer and a cathode on a substrate. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming organic material layers including the hole injection layer, the hole transport layer, the light emitting layer and the electron transport layer thereon, and then depositing a material that can be used as the cathode thereon.

In addition to such a method, the organic light emitting device can be manufactured by sequentially depositing a cathode material, an organic material layer and an anode material on a substrate (International Publication WO 2003/012890).

The organic light emitting device according to the present disclosure may be a front side emission type, a back side emission type, or a double side emission type according to the used material.

**(Coating Composition)**

Meanwhile, the hole transport layer according to the present disclosure can be formed by a solution process. For this purpose, the present disclosure provides a coating composition for forming a hole transport layer comprising a polymer containing a repeating unit represented by Chemical Formula 1, and an anionic compound represented by Chemical Formula 2.

The solvent is not particularly limited as long as it is a solvent capable of dissolving or dispersing the polymer and the compound according to the present disclosure. In one example, the solvent may include chlorine-based solvents such as chloroform, methylene chloride, 1,2-dichloroethane, 1,1,2-trichloroethane, chlorobenzene and o-dichlorobenzene; ether-based solvents such as tetrahydrofuran and dioxane; aromatic hydrocarbon-based solvents such as toluene, xylene, trimethylbenzene, and mesitylene; aliphatic hydrocarbon-based solvents such as cyclohexane, methylcyclohexane, n-pentane, n-hexane, n-heptane, n-octane, n-nonane and n-decane; ketone-based solvents such as acetone, methyl ethyl ketone, and cyclohexanone; ester-based solvents such as ethyl acetate, butyl acetate and ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, and derivatives thereof; alcohol-based solvents such as methanol, ethanol, propanol, isopropanol and cyclohexanol; sulfoxide-based solvents such as dimethyl sulfoxide; amide-based solvents such as N-methyl-2-pyrrolidone and N,N-dimethylformamide; benzoate-based solvents such as butylbenzoate, and methyl-2-methoxybenzoate; tetraline; 3-phenoxy-toluene, and the like. **In** addition, the above-mentioned solvents may be used singly or in combination of two or more solvents.

**In** addition, the viscosity of the coating composition is preferably 1 cP or more. Further, in consideration of the easiness in coating of the coating composition, the viscosity of the coating composition is preferably 10 cP or less. Further, the concentration of the compound according to the present disclosure in the coating composition may be preferably 0.1 wt/v% or more. Further, the concentration of the compound according to the present disclosure in the coating composition is preferably 20 wt/v% or less, so that the coating composition can be optimally coated.

Further, the coating composition may further include one, two or more types of additives selected from the group consisting of a thermal polymerization initiator and a photopolymerization initiator.

Examples of the thermal polymerization initiator may include peroxides such as methyl ethyl ketone peroxide, methyl isobutyl ketone peroxide, acetyl acetone peroxide, methyl cyclohexanone peroxide, cyclohexanone peroxide, isobutyryl peroxide, 2,4-dichlorobenzoyl peroxide, bis-3,5,5-trimethylhexanoyl peroxide, lauryl peroxide, benzoyl peroxide, or azo-based such as azobis isobutylnitrile, azobis dimethylvaleronitrile and azobis cyclohexylnitrile.

Examples of the photopolymerization initiator may include acetophenone-based or ketal-based photopolymerization initiators such as diethoxyacetophenone, 2,2-dimethoxy-1,2-diphenylethan-1-one, 1-hydroxycyclohexyl-phenyl-ketone, 4-(2-hydroxyethoxy)phenyl-(2-hydroxy-2-propyl)ketone, 2-benzyl-2-dimethylamino-1-(4-morpholinophenyl)butanone-1,2-hydroxy-2-methyl-1-phenylpropan-1-one, 2-methyl-2-morpholino(4-methylthiophenyl)propan-1-one and 1-phenyl-1,2-propanedion-2-(o-ethoxycarbonyl)oxime, benzoin ether-based photopolymerization initiators such as benzoin, benzoin methyl ether, and benzoin ethyl ether; benzophenone-based photopolymerization initiators such as benzophenone, 4-hydroxybenzophenone, 2-benzoyl naphthalene, 4-benzoylbiphenyl and 4-benzoylphenyl ether; thioxanthone-based photopolymerization initiators such as 2-isopropylthioxanthone, 2-chlorothioxanthone, 2,4-dimethylthioxanthone, 2,4-diethylthioxanthone and 2,4-dichlorothioxanthone; and other photopolymerization initiators such as ethyl anthraquinone, 2,4,6-trimethylbenzoyldiphenylphosphine oxide, 2,4,6-trimethylbenzoylphenylethoxyphosphine oxide, bis(2,4,6-trimethylbenzoyl)phenylphosphine oxide, and bis(2,4-dimethoxy benzoyl)-2,4,4-trimethylpentylphosphine oxide.

Moreover, those having a photopolymerization promoting effect may also be used alone or in combination with the photopolymerization initiator. Examples thereof include triethanolamine, methyldiethanolamine, ethyl 4-dimethylaminobenzoate, isoamyl 4-dimethylamino benzoate, (2-dimethylamino)ethyl benzoate, and 4,4'-dimethylaminobenzophenone.

**In** another embodiment of the present disclosure, there is provided a method for forming a hole transport layer using the above-mentioned coating composition. Specifically, the method includes the steps of: coating the above-mentioned coating composition for forming a hole transport layer onto the anode by a solution process; and heat-treating or photo-treating the coated coating composition.

The solution process uses the above-mentioned coating composition according to the present disclosure, and refers to spin coating, dip coating, doctor blading, inkjet printing, screen printing, spray method, and roll coating.

The heat treatment temperature in the heat treatment step is preferably from 150 to 230°C. Further, a heat treatment time may be 1 minute to 3 hours, more preferably 10 minutes to 1 hour. Further, the heat treatment is preferably carried out in an inert gas atmosphere such as argon and nitrogen. In addition, a step of evaporating the solvent may be further included between the coating step and the heat treatment or the photo treatment step.

The preparation of the organic light emitting device according to the present disclosure as described above will be described in detail by way of the following examples.

**Preparation Example 1-1: Preparation of Copolymer H1**

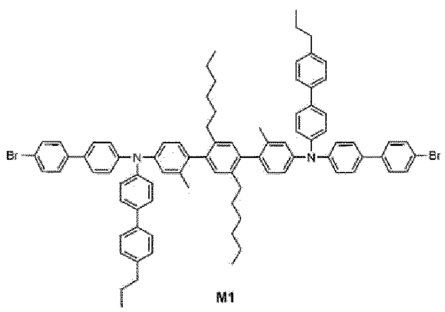

M1

+

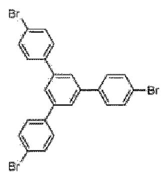

B1

+

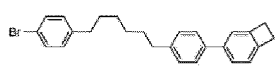

E1

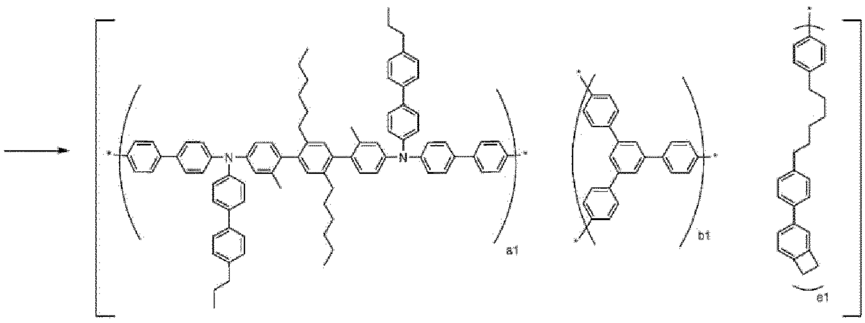

Polymer H1

Compound M1 (0.765 mmol), Compound B1 (0.158 mmol) and Compound E1 (0.396 mmol) were added to a scintillation vial and dissolved in toluene (11 mL) to prepare a first solution.

A 50 mL Schlenk tube was charged with bis(1,5-cyclooctadiene)nickel(0) (2.42 mmol). 2,2'-dipyridyl (2.42 mmol) and 1,5-cyclooctadiene (2.42 mmol) were weighed and added to a scintillation vial, and dissolved in N,N'-dimethylformamide (5.5 mL) and toluene (11 mL) to prepare a second solution.

The second solution was added to a Schlenk tube, and stirred at 50°C for 30 minutes. The first solution was further added to the Schlenk tube and stirred at 50°C for 180 minutes. Then, the Schlenk tube was cooled to room temperature and then poured into HCl/methanol (5% v/v, concentrated HCl). After stirring for 45 minutes, the polymer was collected by vacuum filtration and dried under high vacuum. The polymer was dissolved in toluene (1% wt/v) and passed through a column containing basic aluminum oxide (6 g) layered on silica gel (6 g). The polymer/toluene filtrate was concentrated (2.5% wt/v toluene) and triturated with 3-pentanone. The toluene/3-pentanone solution was decanted from the semi-solid polymer, dissolved in toluene (15 mL) and then poured into stirring methanol to give Copolymer H1 in a yield of 60%.

**Preparation 1-2: Preparation of Copolymer H2**

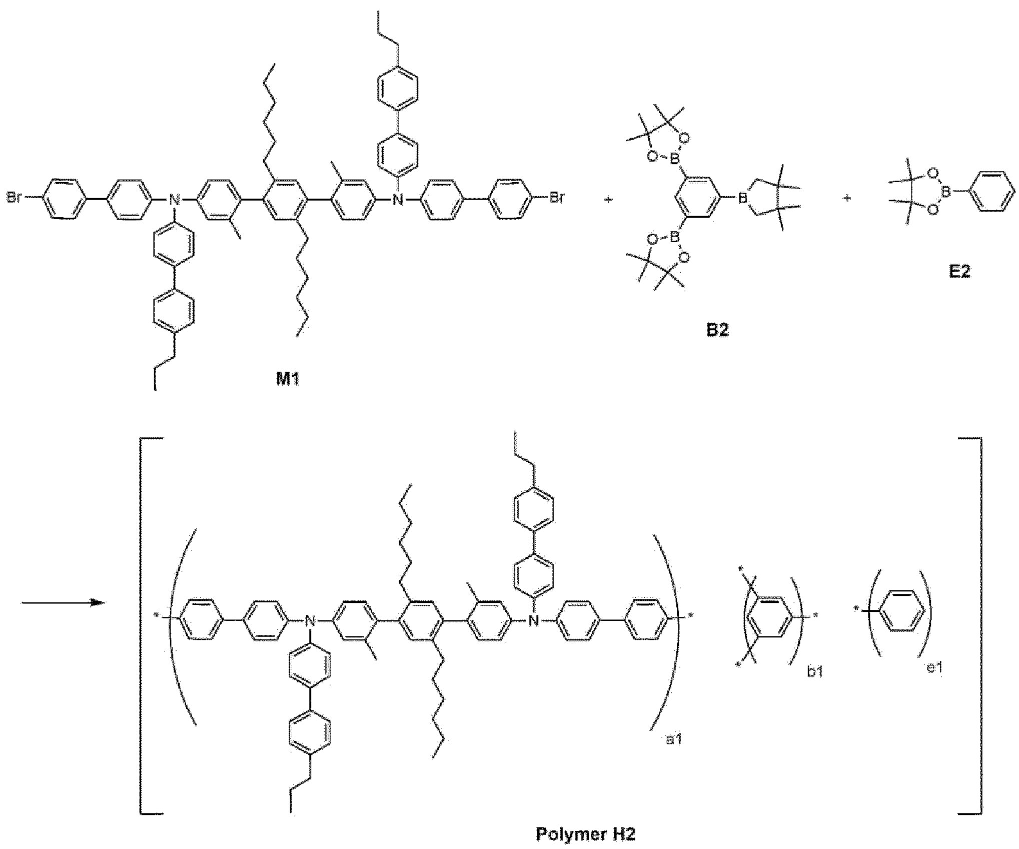

M1 + B2 + E2

Polymer H2

Compound M1 (0.207 mmol), Compound B2 (0.092 mmol), Aliquat 336 (0.041 mmol), 1.24 mL of potassium

carbonate aqueous solution (0.5 M), bis(di-tert-butyl(4-dimethylaminophenyl)phosphine)dichloropalladium(II) (0.1 μmol) and toluene (6.0 mL) were added to a scintillation vial equipped with a magnetic stir bar under inert gas conditions, The vial is sealed with a screw-cap with septum, inserted into an aluminum block, and heated to an external temperature of 105°C over a period of 30 minutes. The mixture was stirred at that temperature under gentle reflux for 5 hours. Then, bis(di-tert-butyl(4-dimethylaminophenyl)phosphine)dichloropalladium(II) (0.05 μmol), Compound E2 (0.138 mmol) and toluene (0.9 ml) were filled in the reaction mixture. The reaction mixture was heated again at the temperature specified above for 1.5 hours. Next, iodobenzene (0.092 mmol) and toluene (0.6 mL) were added thereto. The reaction mixture was heated for an additional 1.5 hours and then cooled to room temperature. The aqueous layer was removed and the organic layer was washed twice with 20 mL each of deionized water. The toluene layer was dried by passing it through 10 g of silica gel and the silica was rinsed with toluene. The solvent was removed to give 250 mg of crude product. The crude product was further purified by passing the toluene solution through alumina, silica gel and Florisil®. After concentration, the solvent-soaked product was diluted to about 14 mL with toluene, and then ethyl acetate (150 mL) was added to give about 200 mg of Copolymer. The product toluene solution was reprecipitated in 3-pentanone to give 145 mg of final Copolymer H2.

**Preparation Example 1-3: Preparation of Copolymer H3**

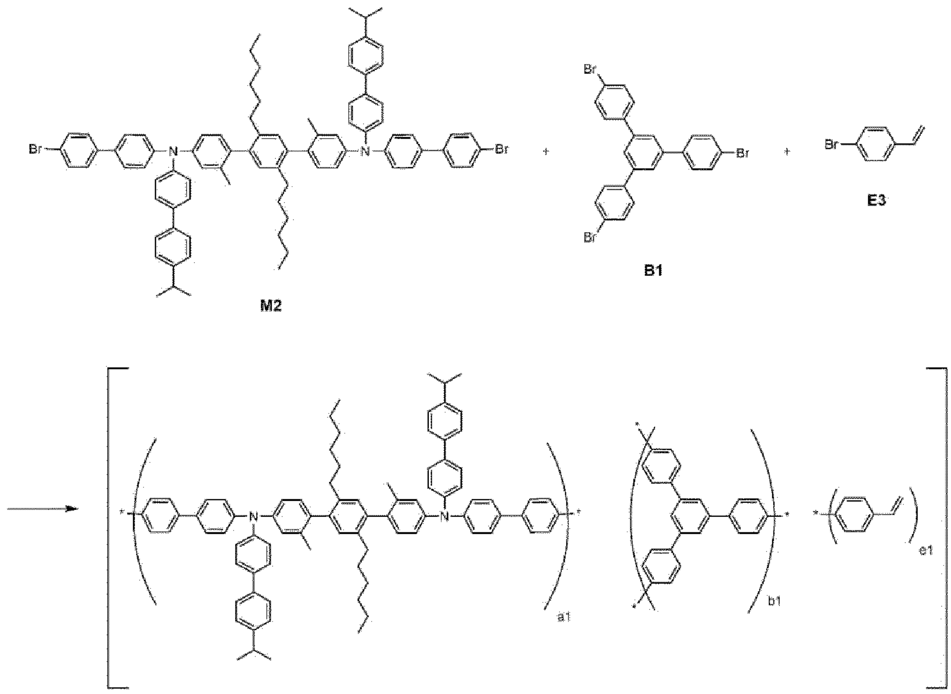

M2 B1 E3

Polymer H3

Copolymer H3 was prepared in the same manner as in the Preparation method of Copolymer H1, except that Compounds M2 and E3 were used instead of Compounds M1 and E1, respectively.

**Preparation Example 1-4: Preparation of Copolymer H4**

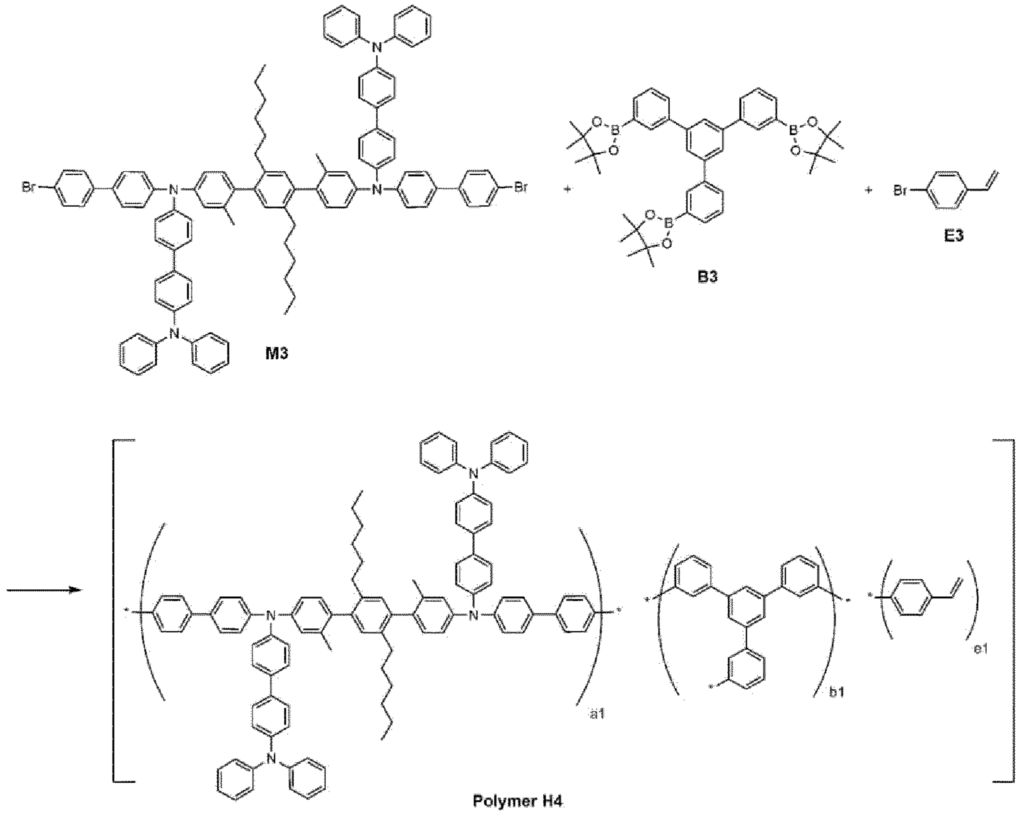

M3 B3 E3

Polymer H4

Copolymer H4 was prepared in the same manner as in the Preparation method of Copolymer H2, except that Compounds M3, B3 and E3 were used instead of Compounds M1, B2 and E2, respectively.

**Preparation Example 1-5: Preparation of Copolymer H5**

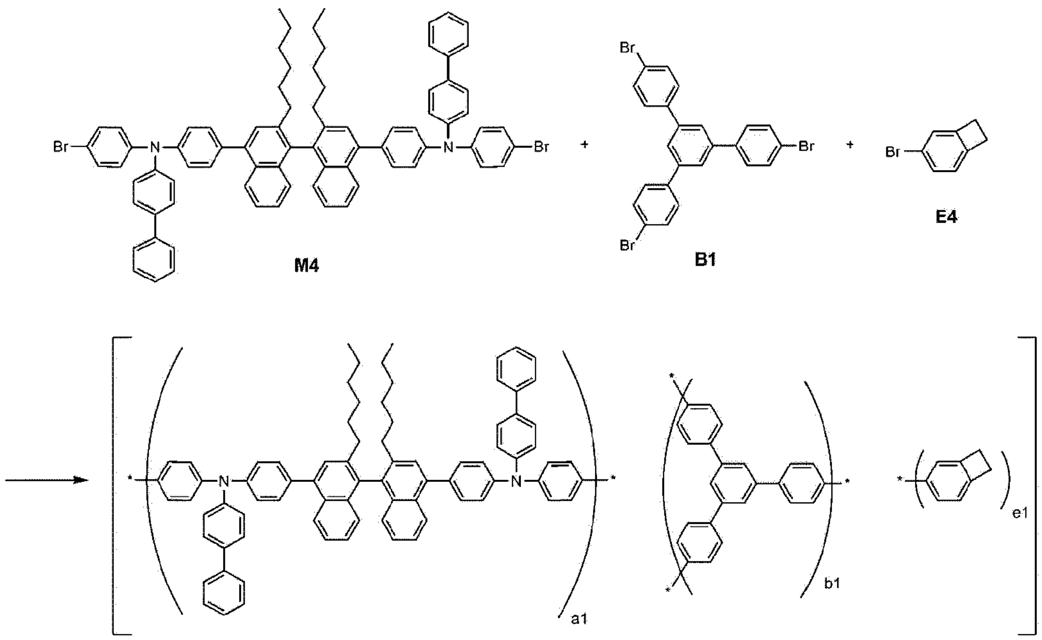

M4 B1 E4

Polymer H5

Copolymer H5 was prepared in the same manner as in the Preparation method of Copolymer H1, except that

Compounds M4 and E4 were used instead of Compounds M1 and E1, respectively.

**Preparation Example 1-6: Preparation of Copolymer H6**

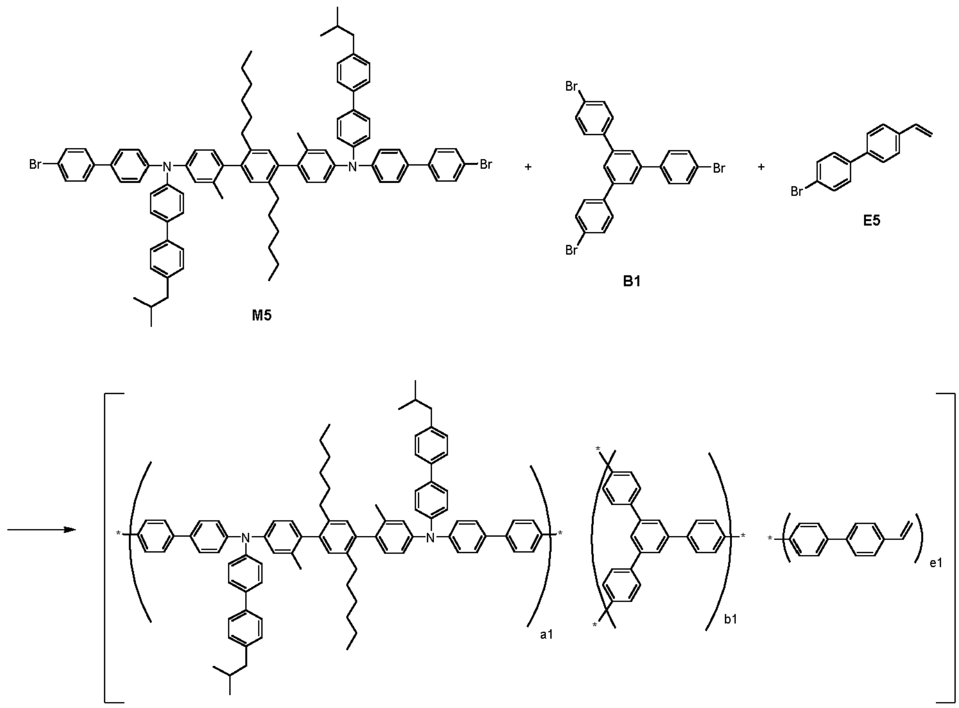

M5 B1 E5

Polymer H6

Copolymer H6 was prepared in the same manner as in the Preparation method of Copolymer H1, except that Compounds M5 and E5 were used instead of Compounds M1 and E1, respectively.

**Preparation Example 1-7: Preparation of Copolymer H7**

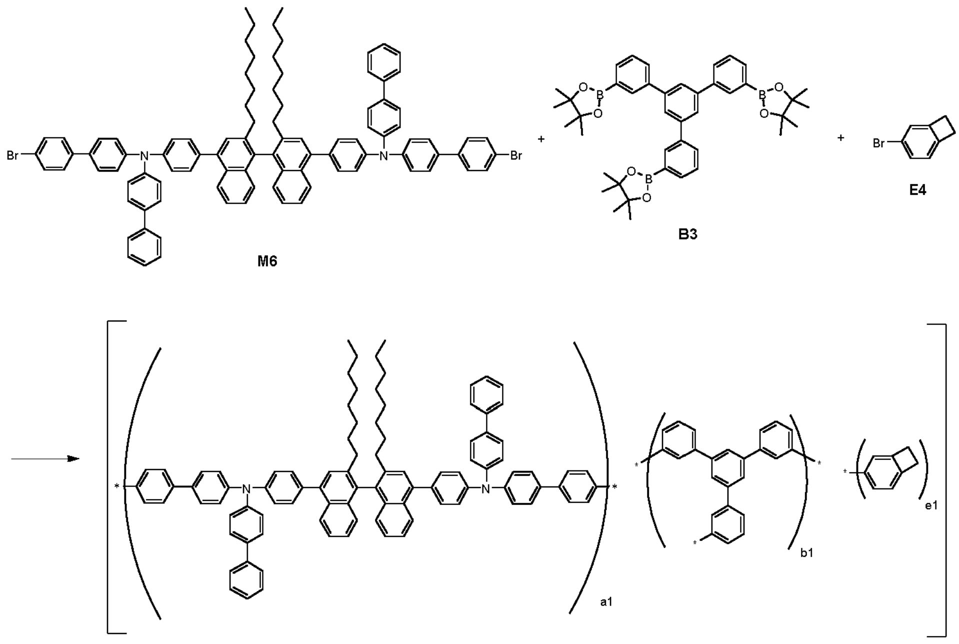

M6 B3 E4

Polymer H7

Copolymer H7 was prepared in the same manner as in the Preparation method of Copolymer H2, except that Compounds M6, B3 and E4 were used instead of Compounds M1, B2 and E2, respectively.

The weight average molecular weight (Mw) and the polydispersity index (PDI, Mw/Mn) of the prepared copolymer were measured by GPC (Agilent 1200 series) using a PS standard, and the prepared copolymer was measured using a solution dissolved in THF at a concentration of 1 mg/1 mL. The results are shown in Table 1 below.

[Table 1]

| | a1:b1:e1 | Mw | PDI |
|---|---|---|---|
| Copolymer H1 | 57:14:30 | 103,000 | 4.1 |
| Copolymer H2 | 60:15:25 | 96,000 | 3.5 |
| Copolymer H3 | 50:25:25 | 150,000 | 2.7 |
| Copolymer H4 | 65:15:20 | 21,2000 | 4.7 |
| Copolymer H5 | 50:30:20 | 75,000 | 3.8 |
| Copolymer H6 | 65:10:25 | 95,000 | 3.4 |
| Copolymer H7 | 62:18:20 | 85,000 | 3.5 |

**Preparation Example 2-1: Preparation of Compound D1**

Step 1) Preparation of Compound D1'

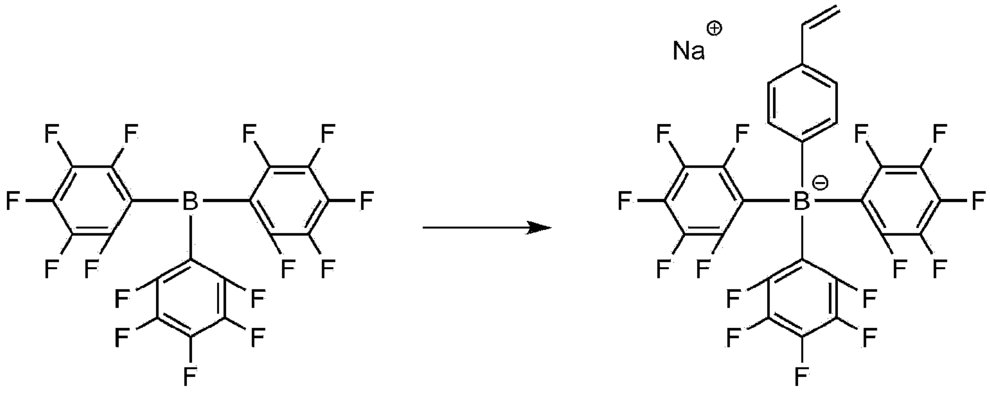

D1'

Mg (193 mg, 7.92 mmol), $I_2$ (4 mg) and THF (10 mL) were added to a 100 mL round-bottom flask under a nitrogen atmosphere, and the mixture was stirred for 30 minutes. 4-Bromostyrene (1.04 mL, 7.92 mmol) was added thereto, and a 30°C water tank was placed under the round bottom flask and stirred for one day. It was confirmed that the reaction solution turned black and Mg was dissolved. Ether (5 mL) was added thereto to dilute the reaction solution. Tris(pentafluorophenyl) borane (1 g, 3.96 mmol) was dissolved in ether (5 mL) and slowly added to the reaction solution for 30 minutes. The solution was stirred for one day. $Na_2CO_3$ (0.1 M, 80 mL, 8.0 mmol) was slowly added to the reaction solution. The organic solvent was extracted using ethyl acetate (20 mL×3) and residual water was removed with $MgSO_4$. In order to additionally remove the residual water and impurities, the resultant was distilled with benzene using a Dean-stock. When about 10 mL of the solvent remained, the solution was cooled and filtered to prepare Compound D1' (1.6 g, yield: 64%).

Step 2) Preparation of Compound D1

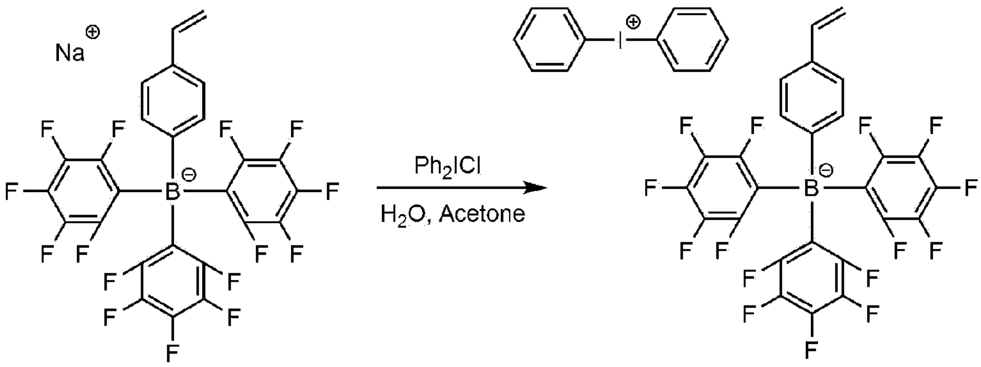


D1' D1

Compound D1' (100 mg, 0.16 mmol), distilled water (10 mL) and $Ph_2ICl$ (60 mg, 0.19 mmol) were added to a 25 mL round bottom flask, and the mixture was stirred for 1 hour. Acetone (15 mL) is added to the reaction solution to form a precipitate, and the precipitate was filtered and dried to prepare Compound D1 (140 mg, yield: 100%).

MS: $[M-H]^-$ = 615 (negative mode)
MS: $[M+H]^+$ = 281 (positive mode)

**Preparation Example 2-2: Preparation of Compound D2**

Step 1) Preparation of Compound D2'

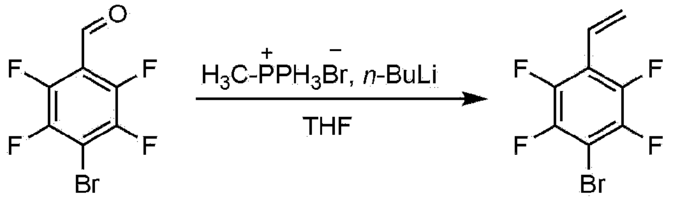


D2'

Methyltriphenyl potassium bromide (13.90 g, 38.91 mmol) and THF (100 mL) were added to a 250 mL round bottom flask, and the mixture was stirred at 0°C for 30 minutes. n-BuLi (15.6 mL, 38.91 mmol, 2.5 M in hexane) was slowly added to the reaction solution, and the mixture was stirred at 0°C for 30 minutes. 4-Formyl-2,3,5,6-tetrafluoro-1-bromobenzene (5.0 g, 19.47 mmol, in 30 mL THF) was slowly added to the reaction solution at 0°C. The reaction solution was stirred while slowly raising the temperature to room temperature. After 3 hours, ether (100 mL) and $NH_4Cl$ saturated solution (400 mL) were added to the reaction solution. The organic solvent was extracted using ether (200 mL × 2), and residual water was removed with $MgSO_4$. The resultant was subjected to column with ethyl acetate:hexane = 1:9 (v:v) to prepare Compound D2' (1.29 g, yield: 26%).

Step 2) Preparation of Compound D2"

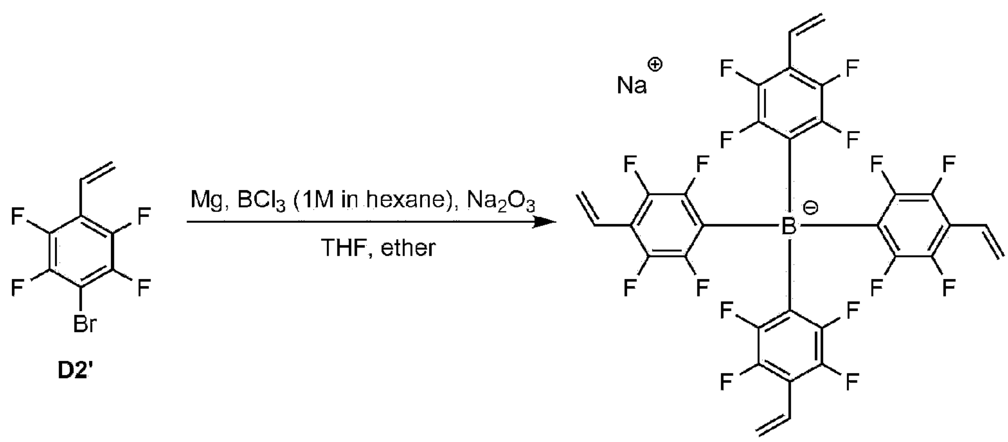


D2"

Mg (95 mg, 3.92 mmol), THF (10 mL) and $I_2$ (4 mg) were added to a 25 mL round bottom flask, and the mixture was stirred. Compound D2' (1.0 g, 3.92 mmol) was added to the reaction solution, and stirred at room temperature. After 10 hours, it was confirmed that the solution turned black and Mg was completely dissolved, and ether (10 mL) and $BCl_3$ (1.3 mL, 1.3 mmol, 1M in hexanes) were added over 30 minutes. The reaction solution was stirred for one day, and then $Na_2CO_3$ (30 mL, 3.0 mmol, 0.1 M in $H_2O$) was added. The synthetic material was extracted with ethyl acetate (10 mL × 3), and then residual water was removed with $MgSO_4$. After removing all the solvent, water was completely removed with benzene using a Dean-stock and the solid was filtered to prepare Compound D2" (340 mg, yield: 28%).

Step 3) Preparation of Compound D2

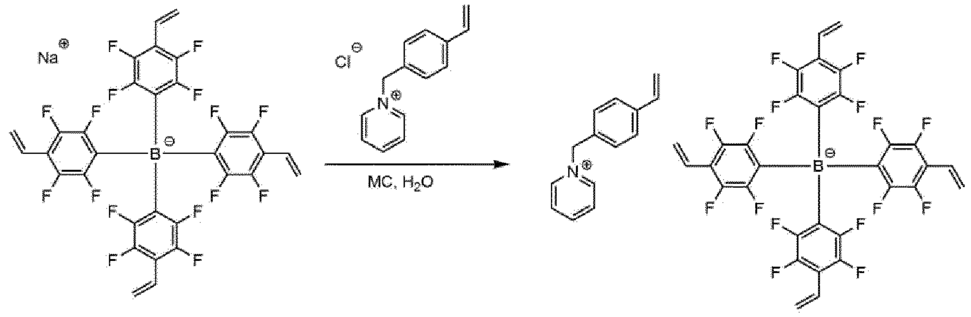


D2"

D2

Compound D2" (200 mg, 0.27 mmol), 1-(4-vinylbenzyl)pyridin-1-ium chloride (69 mg, 0.30 mmol), $H_2O$ (10 mL) and methylene chloride (10 mL) were added to a 25 mL round bottom flask, and the mixture was vigorously stirred for 30 minutes. The organic solvent was extracted using ether (10 mL × 3) and residual water was removed with $MgSO_4$. The solvent was removed and vacuum dried to prepare Compound D2 (247 mg, yield: 100%).

MS: [M-H]- = 711 (negative mode)
MS: [M+H]+ = 196 (positive mode)

**Preparation 2-3: Preparation of Compound D3**

Step 1) Preparation of Compound D3'

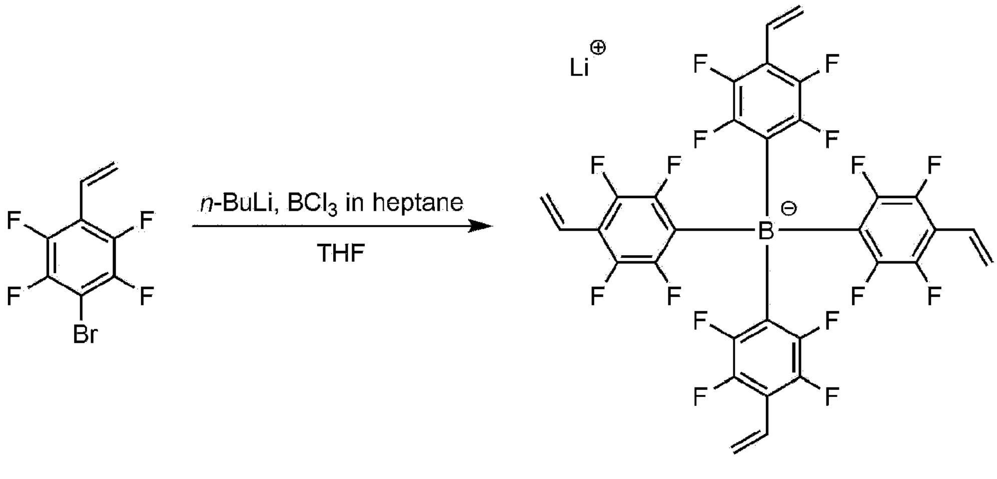


D3'

1-Bromo-2,3,5,6-tetrafluoro-4-vinylbenzene (2 g, 7.84 mmol) was added to THF (20 mL) in a 50 mL round bottom flask, and the mixture was stirred at -78°C for 30 minutes. n-BuLi in hexane (3.45 mL, 8.63 mmol, 2.5 M) was slowly added to the solution, and the mixture was stirred at -78°C for 30 minutes. $BCl_3$ (2.6 mL, 2.61 mmol, 1 M in hexanes) was added to the reaction solution at -78°C for 15 minutes. The reaction solution was stirred for one day while slowly raising the temperature to room temperature, and then water (30 mL) was added thereto. The synthetic material was extracted with ethyl acetate (10 mL × 3), and then all the solvent was removed. Water was completely removed with benzene using a Dean-stock, and the solid was filtered to prepare Compound D3' (800 mg, yield: 43%).

Step 2) Preparation of compound D3

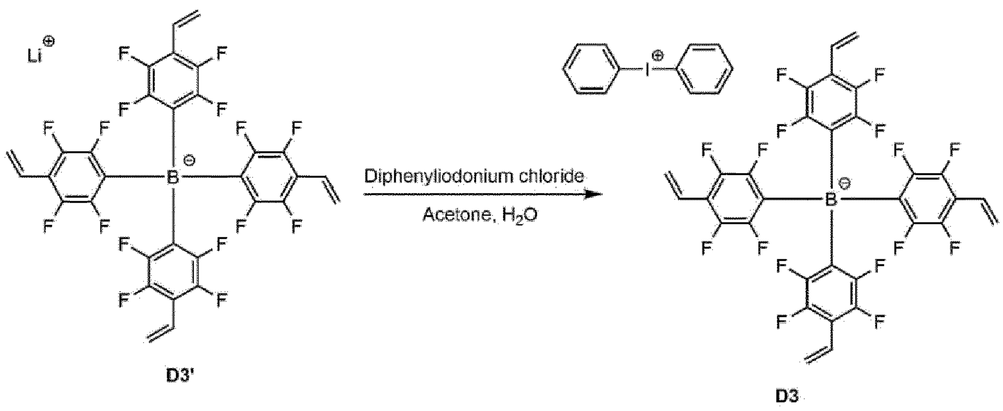


D3'

D3

Compound D3' (400 mg, 0.56 mmol), diphenyliodonium chloride (176 mg, 0.56 mmol), water (10 mL) and acetone (10 mL) were added to a 25 mL round bottom flask, and the mixture was vigorously stirred for 30 minutes. The reaction mixture was extracted using dichloromethane (10 mL × 3), and the solvent was removed and dried to prepare Compound D3 (552 mg, yield: 100%).

MS: [M-H]- = 711 (negative mode)
MS: [M+H]+ = 281 (positive mode)

**Preparation Example 2-4: Preparation of Compound D4**

Step 1) Preparation of Compound D4'

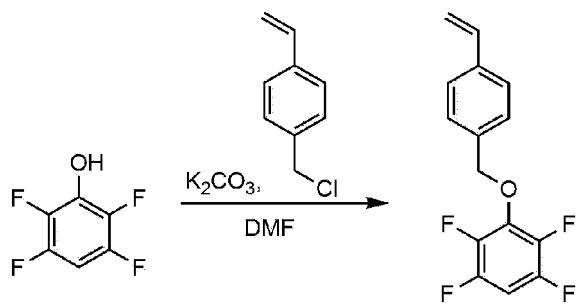


D4'

Potassium carbonate (10.4 g, 75.3 mmol) was added to DMF (200 ml) in a 500 mL round bottom flask. 2,3,5,6-Tetrafluorophenol (10.0 g, 60.22 mmol) was added to the flask, and the mixture was stirred at 60°C for 30 minutes. 4-Vinylbenzyl chloride (7.66 g, 50.18 mmol) was slowly added to the reaction solution, and the mixture was stirred at 60°C for 16 hours. Then, water (300 mL) and ethyl acetate (200 ml) were added thereto. The organic layer was extracted with ethyl acetate (200 mL×2) and residual water was removed with $MgSO_4$. The resultant was subjected to column with ethyl acetate:hexane = 1:9 (v:v) to prepare Compound D4' (11.2 g, yield: 79%).

Step 2) Preparation of compound D4"

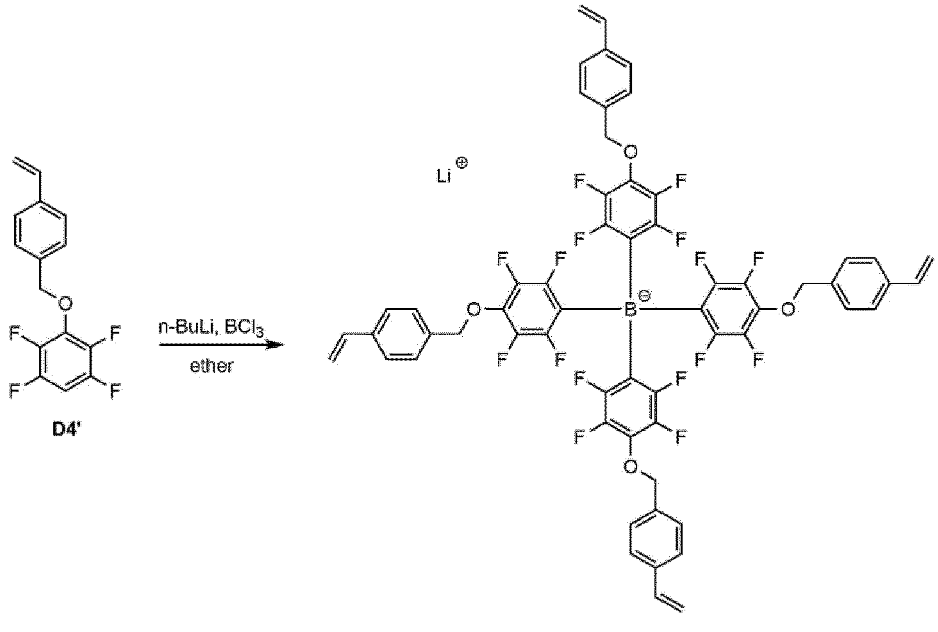


D4'

D4"

Compound D4' (10 g, 35.43 mmol) was added to a 250 ml round bottom flask, to which ether (130 ml) was added and stirred. The reaction solution was cooled to -78°C, and the mixture was stirred for 30 minutes. n-BuLi (17 ml, 42.52 mmol, 2.5 M in hexane) was slowly injected over 30 minutes. Then, the mixture was stirred for 1 hour. $BCl_3$ (8.15 ml, 8.15 mmol, 1 M in hexane) was slowly added over 30 minutes. The temperature of the reaction solution was slowly raised to room temperature. After stirring the reaction solution for one day, water (200 ml) was added thereto. The synthetic material was extracted with ether (100 mL × 3) and all the solvent was removed. Then, water was completely removed with benzene using a Dean-stock and the solid was filtered to prepare Compound D4" (6.2 g, yield: 66%).

Step 3) Preparation of Compound D4

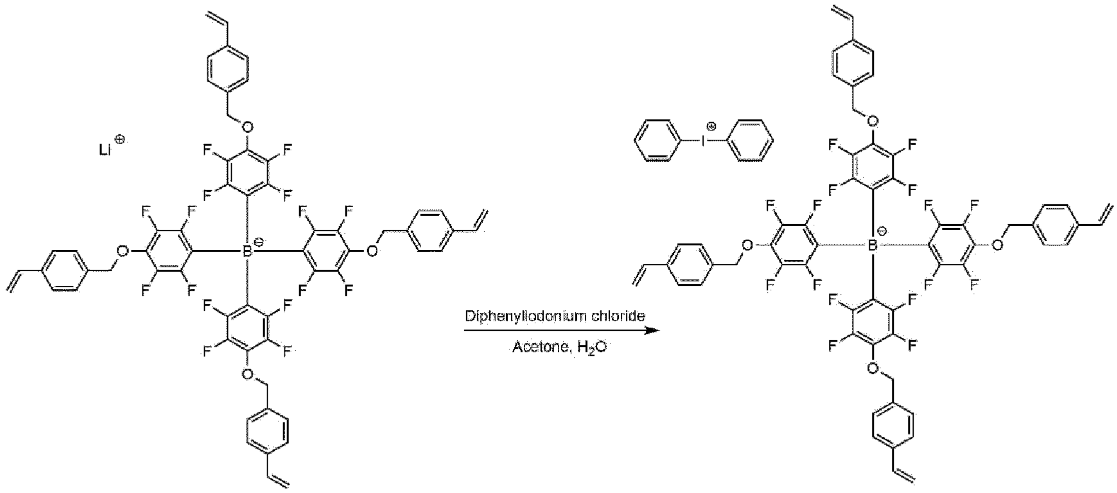


D4"

D4

Compound D4" (6.2 g, 5.42 mmol), diphenylidonium chloride (2.57 g, 8.13 mmol), water (50 mL) and acetone (10 mL) were added to a 25 mL round bottom flask, and the mixture was vigorously stirred for 30 minutes. The organic solvent was extracted using methylene chloride (20 mL × 3) and the solvent was removed. The resultant was subjected to column with methylene chloride:acetone = 9:1 (v:v) to prepare Compound D4 (5.0 g, yield: 65%).

MS: $[M-H]^-$ = 1135 (negative mode)

MS: $[M+H]^+$ = 281 (positive mode)

**[Device Example]**

**Example 1**

A glass substrate on which ITO was coated as a thin film to a thickness of 1500 Å was ultrasonically cleaned using an acetone solvent for 10 minutes. The substrate was then put into distilled water in which a detergent was dissolved, ultrasonically cleaned for 10 minutes, and then ultrasonic cleaning was repeated twice using distilled water for 10 minutes. After the cleaning with distilled water was completed, the substrate was ultrasonically cleaned with a solvent of isopropyl alcohol for 10 minutes, and then dried. The substrate was then transported to a glove box.

On the transparent ITO electrode prepared as above, a 2 wt% cyclohexanone solution containing the previously prepared Copolymer H1 and Compound D1 in a weight ratio of 8:2 was spin-coated and heat-treated at 230°C for 30 minutes to form a hole injection layer with a thickness of 600 Å. A 0.8 wt% toluene solution containing the following Polymer HTL (weight average molecular weight: 83,661; measured by GPC (Agilent 1200 series) using a PS standard) was spin-coated onto the hole injection layer to form a hole transport layer with a thickness of 140 nm.

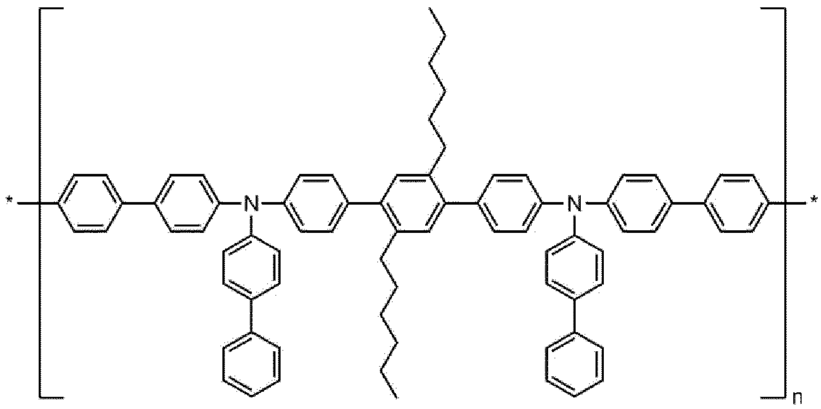

**HTL**

Then, on the hole transport layer, a 1.3 wt% solution containing the following Compound A and the following Compound B in a weight ratio of 9:1 was prepared and then subjected to a solution process to form a light emitting layer with a thickness of 550 Å. The following Compound C was vacuum-deposited on the light emitting layer to form an electron injection and transport layer with a thickness of 400 Å. LiF having a thickness of 5 Å and aluminum having a thickness of 1000 Å were sequentially deposited on the electron injection and transport layer, thereby forming a cathode.

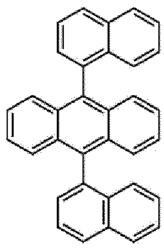

A

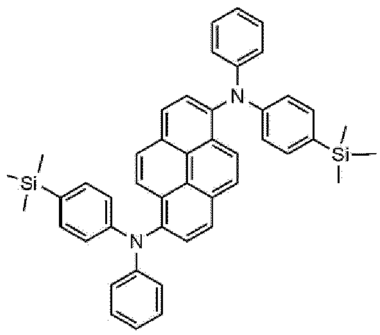

B

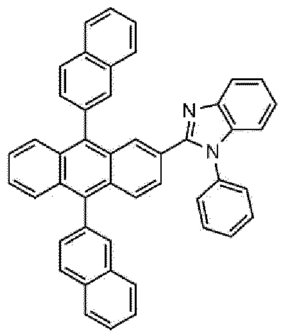

C

In the above-mentioned processes, the deposition rates of the organic materials were maintained at 0.4 to 1.0 Å/sec, the deposition rates of the LiF and the aluminum were maintained at 0.3 Å/sec and 2 Å/sec, respectively, and the degree of vacuum during the deposition was maintained at $2\times10^{-8}$ to $5\times10^{-6}$ torr.

**Examples 2 to 12**

The organic light emitting devices were manufactured in the same manner as in Example 1, except that during the manufacture of the hole injection layer, Compounds described in Table 2 below were used instead of Copolymer H1 and/or Compound D1.

**Comparative Examples 1 and 2**

The organic light emitting devices were manufactured in the same manner as in Example 1, except that during the manufacture of the hole injection layer, Compounds described in Table 2 below were used instead of Copolymer H1 and/or Compound D1. Comparative Compounds shown in Table 2 below are as follows.

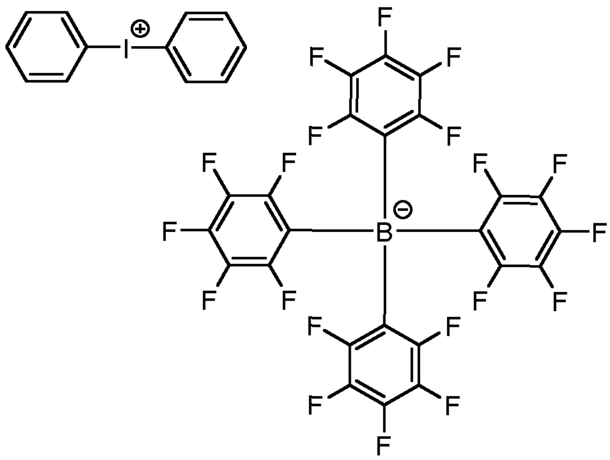

For the organic light emitting devices manufactured in Examples and Comparative Examples, the driving voltage, external quantum efficiency (EQE) and lifetime were measured at a current density of 10 mA/cm$^2$, and the results are shown in Table 2 below. The external quantum efficiency was determined by (number of photons emitted)/(number of charge carriers injected), and the lifetime(T95) means the time required for the luminance to be reduced to 95% of the initial luminance

[Table 2]

| | Host | Dopant | Driving voltage(V) | EQE (%) | T95(hr) |
|---|---|---|---|---|---|
| Example 1 | Copolymer H1 | Compound D1 | 4.56 | 5.73 | 229 |
| Example 2 | Copolymer H1 | Compound D2 | 5.58 | 6.03 | 156 |
| Example 3 | Copolymer H2 | Compound D3 | 4.65 | 5.99 | 132 |
| Example 4 | Copolymer H2 | Compound D4 | 4.63 | 5.96 | 194 |
| Example 5 | Copolymer H3 | Compound D2 | 4.54 | 5.82 | 296 |
| Example 6 | Copolymer H3 | Compound D3 | 4.40 | 5.83 | 128 |
| Example 7 | Copolymer H4 | Compound D1 | 4.67 | 6.17 | 156 |
| Example 8 | Copolymer H4 | Compound D4 | 4.25 | 5.57 | 149 |
| Example 9 | Copolymer H5 | Compound D1 | 4.49 | 5.76 | 191 |
| Example 10 | Copolymer H5 | Compound D3 | 4.89 | 6.09 | 188 |
| Example 11 | Copolymer H6 | Compound D1 | 4.92 | 5.46 | 125 |
| Example 12 | Copolymer H7 | Compound D2 | 4.55 | 5.64 | 114 |
| Comparative Example 1 | Copolymer H3 | - | 3.92 | 0.92 | 1 |
| Comparative Example 2 | Copolymer H3 | Comparative Compound 1 | 3.61 | 2.23 | 35 |

As shown in Table 2, it was confirmed that when the polymer containing the repeating unit represented by

Chemical Formula 1 and the ionic compound containing the anionic group represented by Chemical Formula 2 according to the present disclosure were used in the hole transport layer, the external quantum efficiency and lifetime were excellent.

On the other hand, it was confirmed that in the case of Comparative Example 1, in which the ionic compound containing an anionic group represented by Chemical Formula 2 according to the present disclosure was not used in the hole transport layer, the lifetime was extremely short, and it could not be actually used as an organic light emitting device, and also that unlike the ionic compound containing an anionic group represented by Chemical Formula 2 according to the present disclosure, in the case of Comparative Example 2, in which Comparative Compound 1 without a photocurable group or a thermosetting group was used as a dopant for the hole transport layer, the external quantum efficiency and lifetime were significantly reduced.

**[Measurement of curing conversion rate]**

As shown in Table 3 below, a 2 wt% cyclohexanone solution made with the previously prepared Copolymer alone, or a 2 wt% cyclohexanone solution containing the copolymer and the dopant compound prepared above in a weight ratio of 80:20 was prepared, and then each of them was spin-coated and heat-treated at 230°C for 30 minutes to obtain a thin film. The UV-vis absorption spectrum of the thin film was measured, and the absorbance index (a1) at the point where the maximum absorption appeared was measured. Then, the thin film was immersed in cyclohexanone for 10 minutes, then taken out, and the UV-vis absorption spectrum was measured and the absorbance index (a2) at the point where the maximum absorption appeared was measured. The curing conversion rate was calculated from the two measured values according to the following Equation 1.

[Equation 1]

$$\text{Curing conversion rate (\%)} = (a2 / a1) * 100$$

[Table 3]

| Host | Dopant | Host:Dopant | Curing conversion |
|---|---|---|---|
| | | (weight ratio) | rate (%) |
| Copolymer H3 | - | 100:0 | 64 |
| Copolymer H3 | Compound D1 | 80:20 | 100 |
| Copolymer H4 | - | 100:0 | 73 |
| Copolymer H4 | Compound D4 | 80:20 | 100 |

As shown in Table 3, it was confirmed that compared to the case of using the copolymer alone, the case of using it together with the dopant was significantly increased in the curing conversion rate. Without being theoretically limited, the above result shows that curing proceeds more smoothly by the photocurable group or thermosetting group of the ionic compound containing an anionic group represented by Chemical Formula 2 according to the present disclosure.

**[Explanation of symbols]**

| | | | |
|---|---|---|---|
| 1: | substrate | 2: | anode |
| 3: | hole transport layer | 4: | light emitting layer |
| 5: | cathode | 6: | electron transport layer |
| 7: | electron injection layer | | |

## Claims

**1.** An organic light emitting device comprising:

an anode (2),
a cathode (5),
a light emitting layer (4) between the anode and the cathode, and
a hole transport layer (3) between the anode and the light emitting layer,
wherein said hole transport layer may be a hole injection layer, a hole transport layer, or a layer that simultaneously injects and transports holes; and
wherein said hole transport layer comprises a polymer containing a repeating unit represented by the following Chemical Formula 1, and an ionic compound containing an anionic group represented by the following Chemical Formula 2:

[Chemical Formula 1]

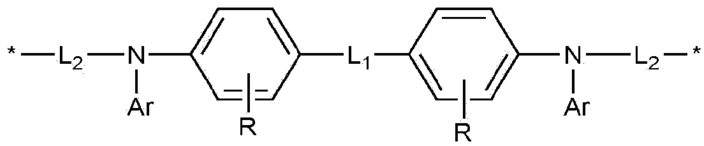

wherein in Chemical Formula 1,

$L_1$ is a substituted or unsubstituted $C_{6-60}$ arylene,
each $L_2$ is independently a substituted or unsubstituted $C_{6-60}$ arylene,
each Ar is independently a substituted or unsubstituted $C_{6-60}$ aryl,
each R is independently hydrogen, deuterium, or a substituted or unsubstituted $C_{1-10}$ alkyl,

[Chemical Formula 2]

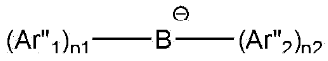

wherein in Chemical Formula 2,

n1 and n2 are each independently an integer of 1 to 3, with the proviso that n1+n2 is 4,
$Ar''_1$ is

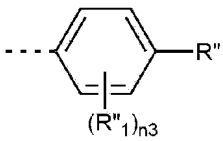

,

R" is a photocurable group; or a thermosetting group,
each $R''_1$ is independently hydrogen, halogen, or a $C_{1-60}$ haloalkyl, n3 is an integer of 1 to 4,

$Ar''_2$is

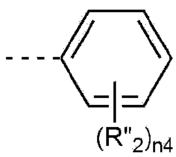

,

each $R''_2$ is independently hydrogen, halogen, a $C_{1-60}$ haloalkyl, a photocurable group, or a thermosetting group, and
n4 is an integer of 1 to 5;

wherein the polymer further comprises a repeating unit selected from the group consisting of the following:

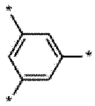 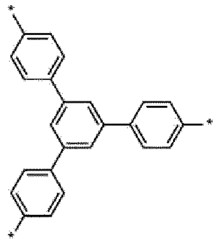 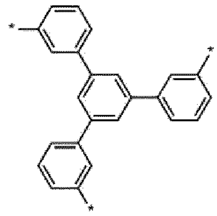 .

**2.** The organic light emitting device of claim 1, wherein: $L_1$ is phenylene, biphenyldiyl, or binaphthyldiyl, and the $L_1$ is unsubstituted or substituted with one or two $C_{1-10}$ alkyl, or one or more deuterium.

**3.** The organic light emitting device of claim 1, wherein: $L_1$ is represented by any one of the following:

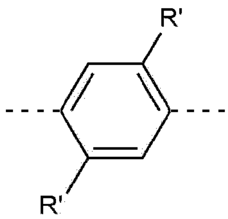 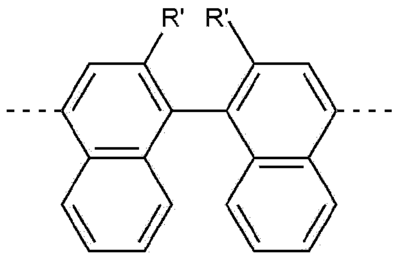

wherein, each R' is independently a $C_{1-10}$ alkyl.

**4.** The organic light emitting device of claim 3, wherein: each R' is independently methyl, propyl, butyl, pentyl, or hexyl.

**5.** The organic light emitting device of claim 1, wherein: each $L_2$ is independently phenylene, or biphenyldiyl, and the $L_2$ is unsubstituted or substituted with one or more deuterium.

**6.** The organic light emitting device of claim 1, wherein: each Ar is independently phenyl, or biphenylyl, and the Ar is unsubstituted or substituted with a $C_{1-10}$ alkyl, a $N(C_{6-60}\ aryl)_2$, or one or more deuterium.

**7.** The organic light emitting device of claim 1, wherein: Ar is biphenylyl, and the Ar is unsubstituted or substituted with propyl, isopropyl, butyl, isobutyl, $N(phenyl)_2$, or one or more deuterium.

**8.** The organic light emitting device of claim 1, wherein: each R is independently hydrogen, deuterium, or methyl.

**9.** The organic light emitting device of claim 1, wherein: the Chemical Formula 1 is represented by any one selected from the group consisting of the following:

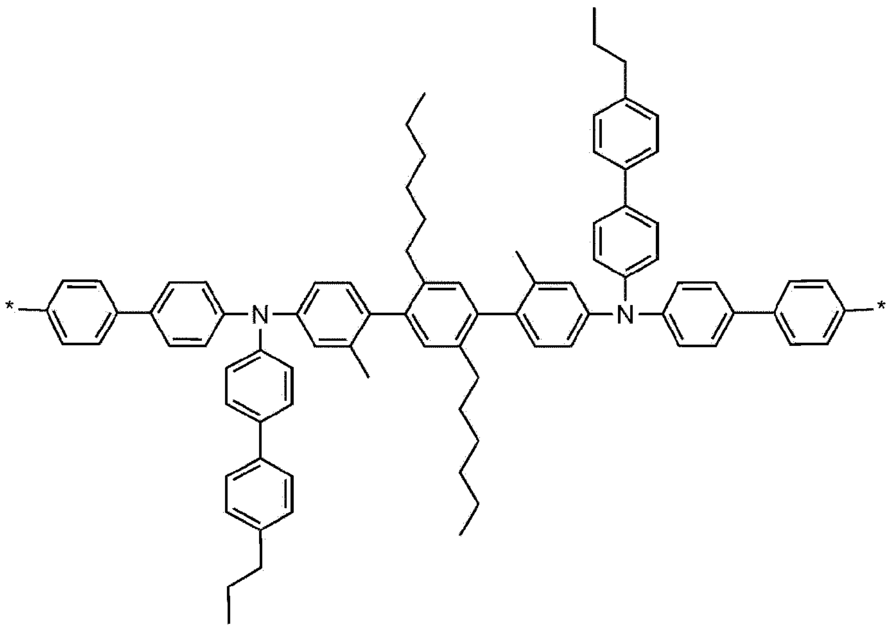

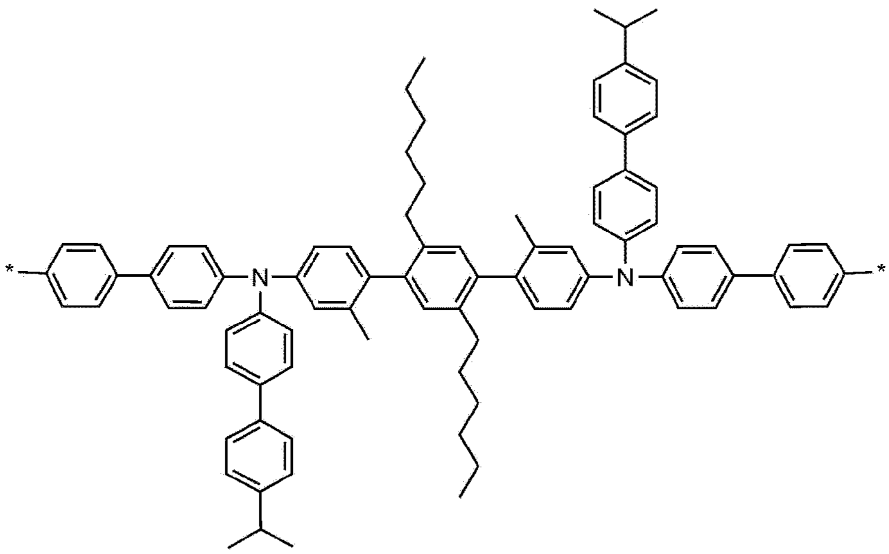

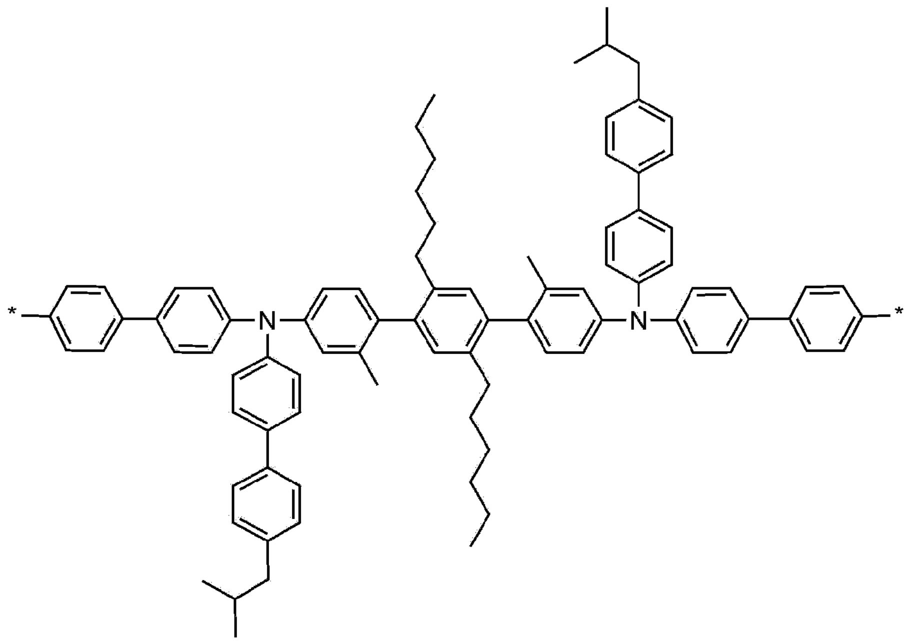

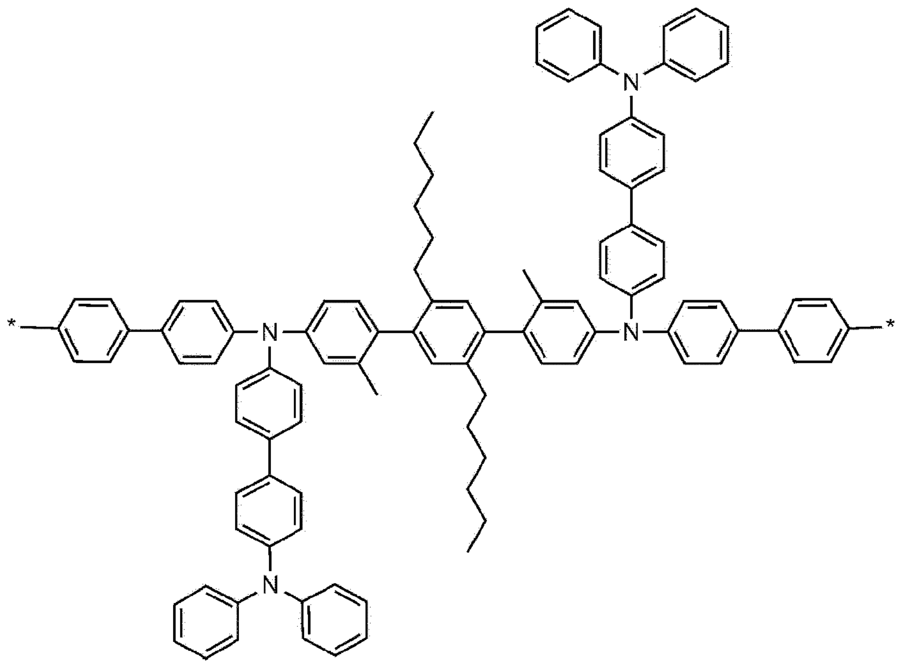

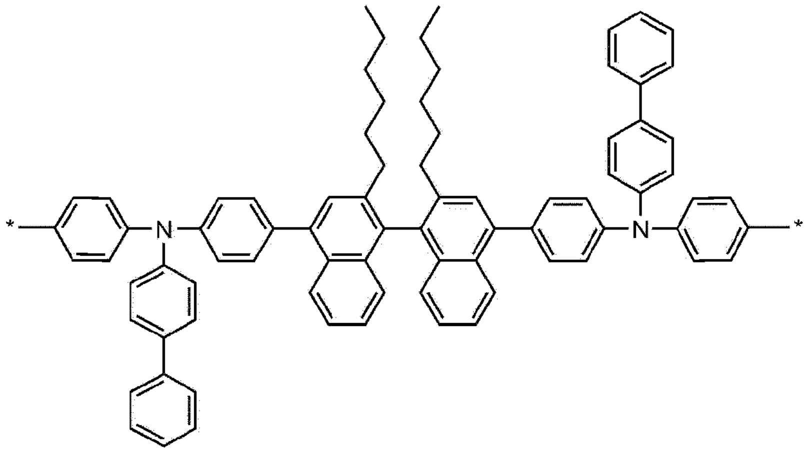

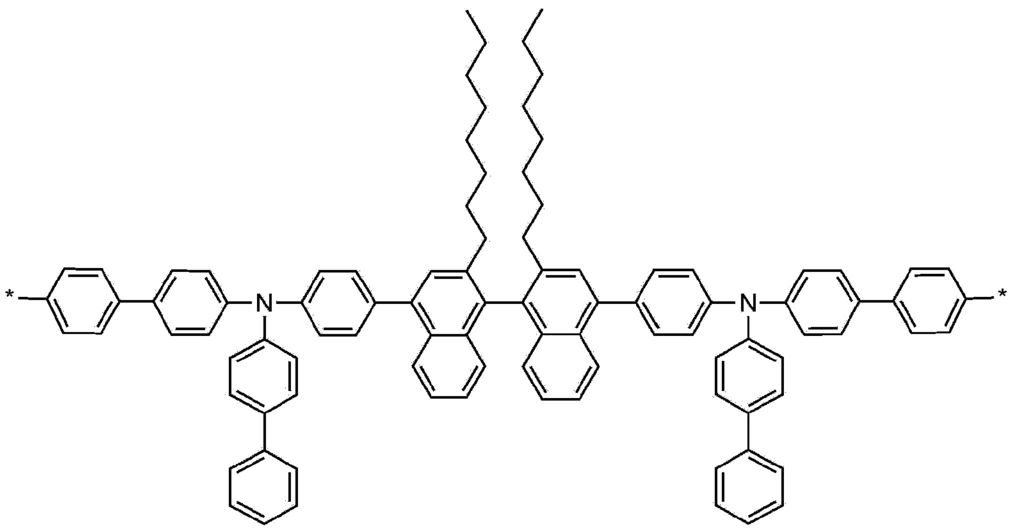

**10.** The organic light emitting device of claim 1, wherein: each $R''_1$ is independently hydrogen, fluoro, or $CF_3$.

**11.** The organic light emitting device of claim 1, wherein: $Ar''_1$ is any one selected from the group consisting of the following:

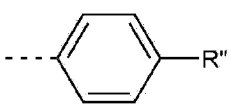 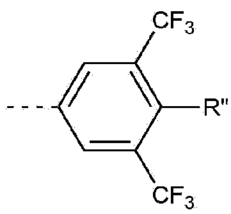 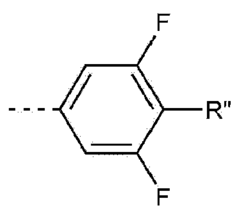 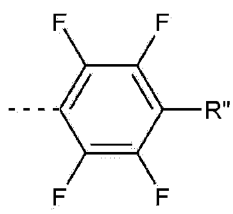

**12.** The organic light emitting device of claim 1, wherein: each $R''_1$ is independently hydrogen, fluoro, $CF_3$, $CF(CF_3)_2$, $CF_2CF_2CF_2CF_3$, a photocurable group, or a thermosetting group.

**13.** The organic light emitting device of claim 1, wherein: $Ar''_2$ is any one selected from the group consisting of the following:

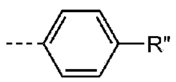
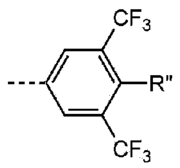
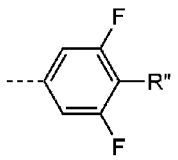
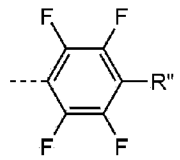

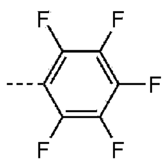
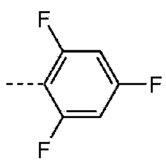
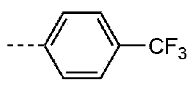
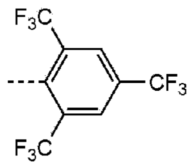

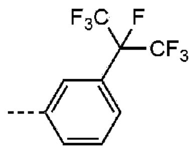
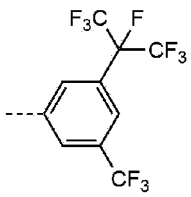
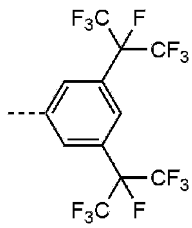
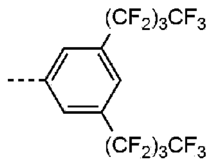

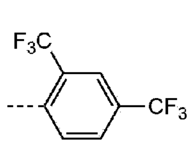
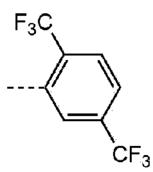

**14.** The organic light emitting device of claim 1, wherein:
the anionic group represented by Chemical Formula 2 is any one selected from the group consisting of the following:

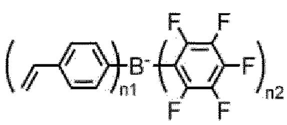
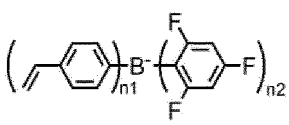
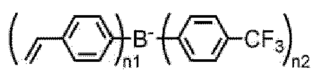

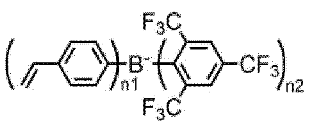
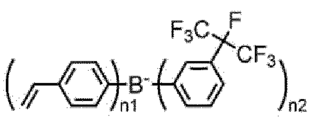
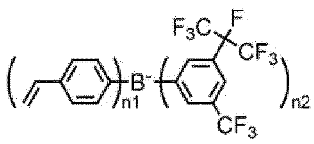

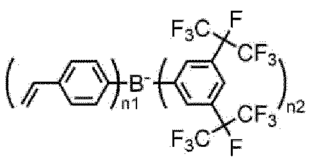
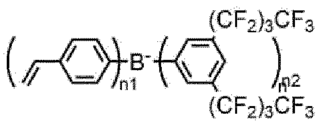
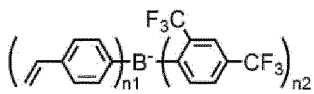

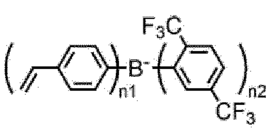
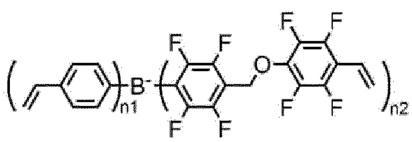
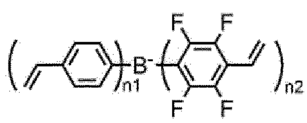

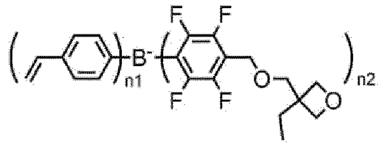

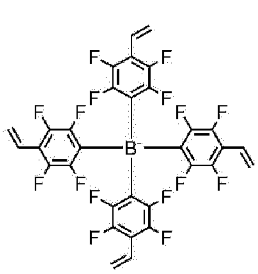

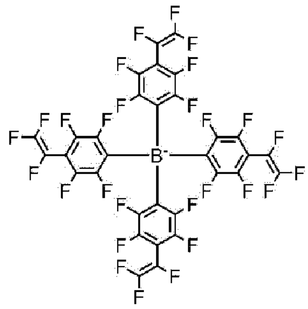

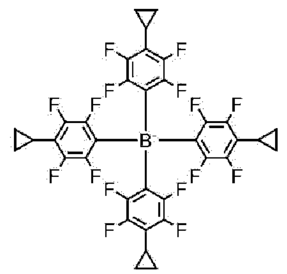

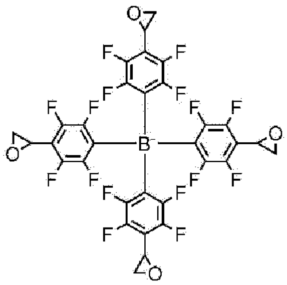

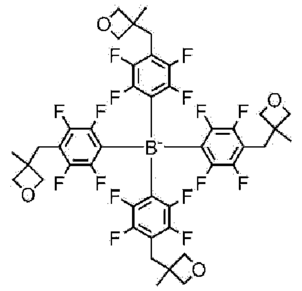

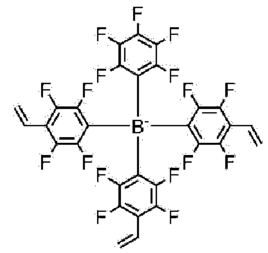

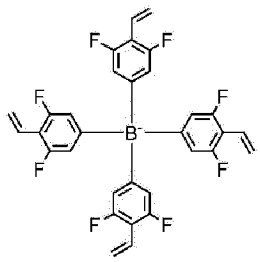

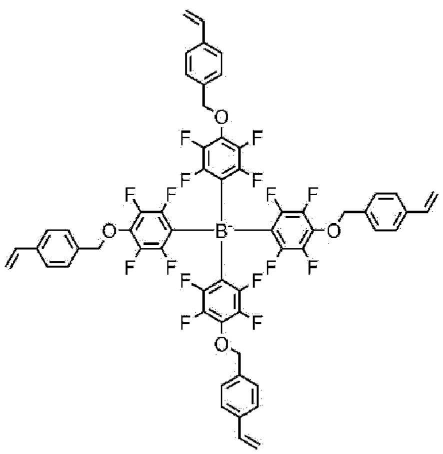

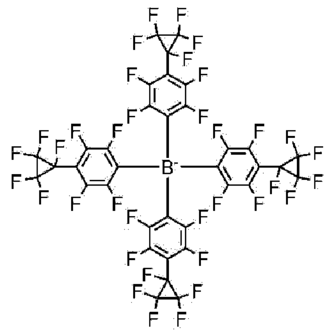

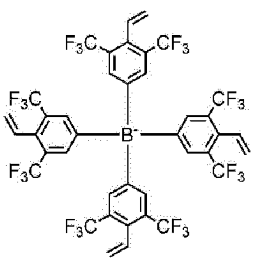

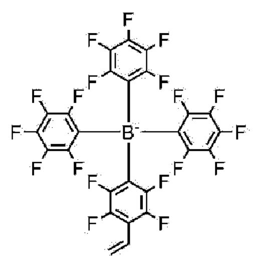

**15.** The organic light emitting device of claim 1, wherein:
the anionic compound contains a cationic group, and the cationic group is selected from a monovalent cationic group, an onium compound or the following structural formulas:

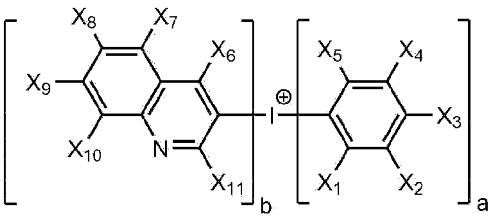

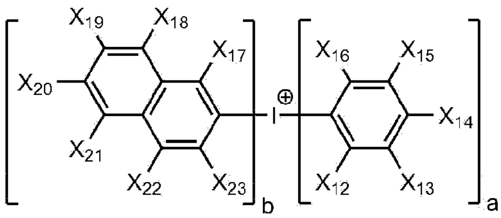

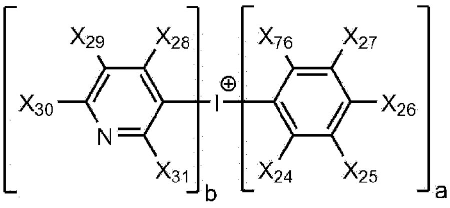

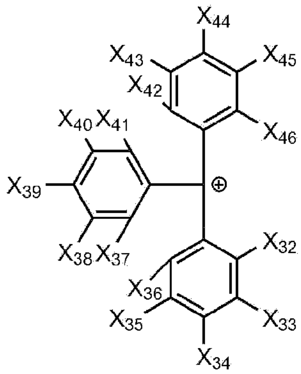

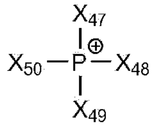

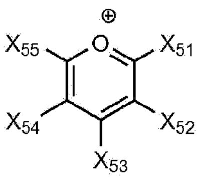

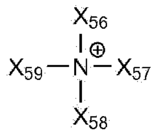

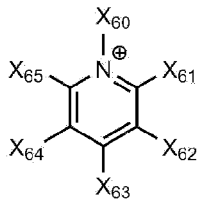

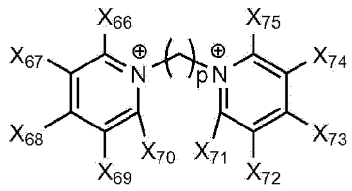

wherein,

$X_1$ to $X_{76}$ are each independently hydrogen; cyano; nitro; halogen; - $COOR_{104}$; a substituted or unsubstituted $C_{1-60}$ alkyl; a substituted or unsubstituted $C_{1-60}$ alkoxy; a substituted or unsubstituted $C_{3-60}$ cycloalkyl; a substituted or unsubstituted $C_{1-60}$ fluoroalkyl; or a substituted or unsubstituted $C_{6-60}$ aryl; or a curable group,
$R_{104}$ is hydrogen; deuterium; or a substituted or unsubstituted $C_{1-60}$ alkyl,
p is an integer of 0 to 10,
a is 1 or 2, b is 0 or 1, and a+b=2.

**16.** The organic light emitting device of claim 15, wherein:
the cationic group is any one selected from the group consisting of the following:

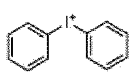

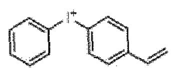

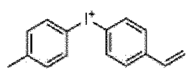

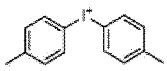

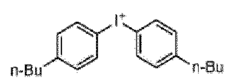

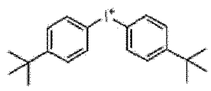

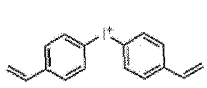

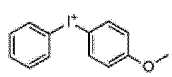

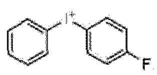

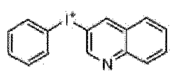

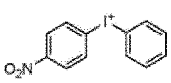

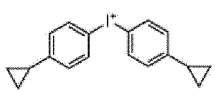

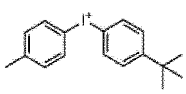

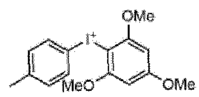

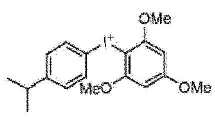

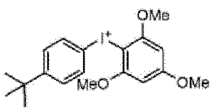 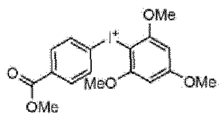 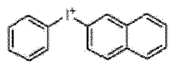 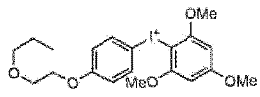 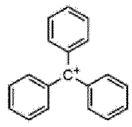

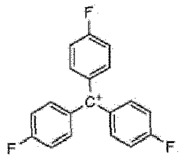 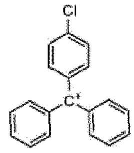 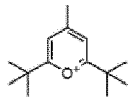 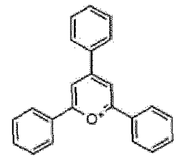 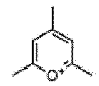

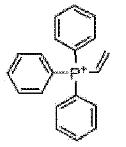 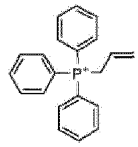 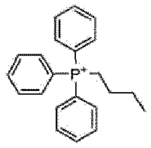 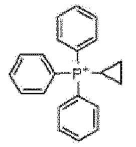 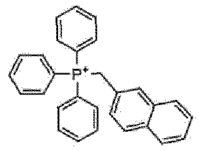

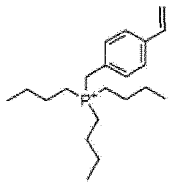 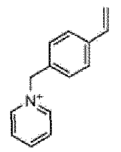 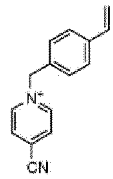 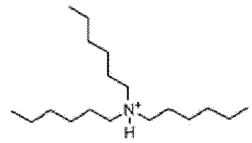 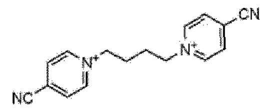

## Patentansprüche

1. Organische lichtemittierende Vorrichtung, umfassend:

eine Anode (2),
eine Kathode (5),
eine lichtemittierende Schicht (4) zwischen der Anode und der Kathode und
eine Lochtransportschicht (3) zwischen der Anode und der lichtemittierenden Schicht,
worin die Lochtransportschicht eine Lochinjektionsschicht, eine Lochtransportschicht oder eine Schicht, die gleichzeitig Löcher injiziert und transportiert, sein kann, und
worin die Lochtransportschicht ein Polymer, das eine durch die folgende chemische Formel 1 dargestellte Wiederholungseinheit enthält, und eine ionische Verbindung, die eine durch die folgende chemische Formel 2 dargestellte anionische Gruppe enthält, umfasst:

[Chemische Formel 1]

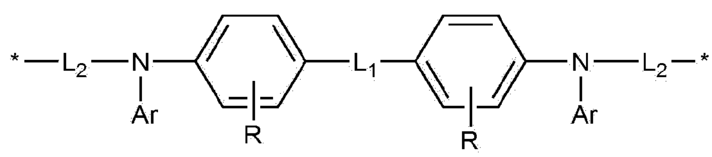

worin in der chemischen Formel 1

$L_1$ ein substituiertes oder unsubstituiertes $C_{6-60}$-Arylen ist,
jedes $L_2$ unabhängig ein substituiertes oder unsubstituiertes $C_{6-60}$-Arylen ist,
jedes Ar unabhängig ein substituiertes oder unsubstituiertes $C_{6-60}$-Aryl ist,
jedes R unabhängig Wasserstoff, Deuterium oder ein substituiertes oder unsubstituiertes $C_{1-10}$-Alkyl ist,

[Chemische Formel 2]

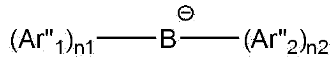

worin in der chemischen Formel 2

n1 und n2 jeweils unabhängig eine ganze Zahl von 1 bis 3 sind, vorausgesetzt, dass n1+n2 4 ist,
Ar"$_1$

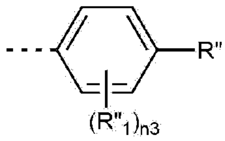

ist,
R" eine foto-härtbare Gruppe; oder eine warmhärtende Gruppe ist,
jedes R"$_1$ unabhängig Wasserstoff, Halogen oder ein $C_{1-60}$-Haloalkyl ist,
n3 eine ganze Zahl von 1 bis 4 ist,
Ar"$_2$

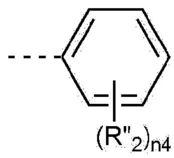

ist,
worin jedes R"$_2$ unabhängig Wasserstoff, Halogen, ein $C_{1-60}$-Haloalkyl, eine foto-härtbare Gruppe oder eine warmhärtende Gruppe ist, und
n4 eine ganze Zahl von 1 bis 5 ist;
worin das Polymer ferner eine Wiederholungseinheit umfasst, ausgewählt aus der Gruppe bestehend aus den Folgenden:

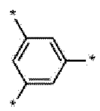 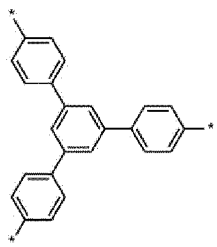 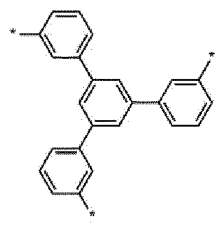 .

**2.** Organische lichtemittierende Vorrichtung gemäß Anspruch 1, worin:

$L_1$ Phenylen, Biphenyldiyl oder Binaphthyldiyl ist und
das $L_1$ unsubstituiert ist oder substituiert ist mit ein oder zwei $C_{1-10}$-Alkyl oder einem oder mehr Deuterium.

**3.** Organische lichtemittierende Vorrichtung gemäß Anspruch 1, worin:
$L_1$ durch irgendeines der Folgenden dargestellt ist:

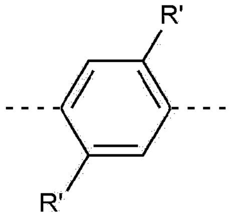

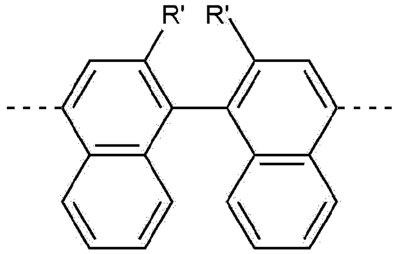

worin R' unabhängig ein $C_{1-10}$-Alkyl ist.

**4.** Organische lichtemittierende Vorrichtung gemäß Anspruch 3, worin: jedes R' unabhängig Methyl, Propyl, Butyl, Pentyl oder Hexyl ist.

**5.** Organische lichtemittierende Vorrichtung gemäß Anspruch 1, worin:

jedes $L_2$ unabhängig Phenylen oder Biphenyldiyl ist und
das $L_2$ unsubstituiert ist oder substituiert ist mit ein oder mehr Deuterium.

**6.** Organische lichtemittierende Vorrichtung gemäß Anspruch 1, worin:

jedes Ar unabhängig Phenyl oder Biphenylyl ist und
das Ar unsubstituiert ist oder substituiert ist mit einem $C_{1-10}$-Alkyl, einem $N(C_{6-60}\text{-Aryl})_2$ oder einem oder mehr Deuterium.

**7.** Organische lichtemittierende Vorrichtung gemäß Anspruch 1, worin:

Ar Biphenylyl ist und
das Ar unsubstituiert ist oder substituiert ist mit Propyl, Isopropyl, Butyl, Isobutyl, $N(Phenyl)_2$ oder einem oder mehr Deuterium.

**8.** Organische lichtemittierende Vorrichtung gemäß Anspruch 1, worin: jedes R unabhängig Wasserstoff, Deuterium oder Methyl ist.

**9.** Organische lichtemittierende Vorrichtung gemäß Anspruch 1, worin: die chemische Formel 1 dargestellt ist durch irgendeines, das ausgewählt aus der Gruppe bestehend aus den Folgenden:

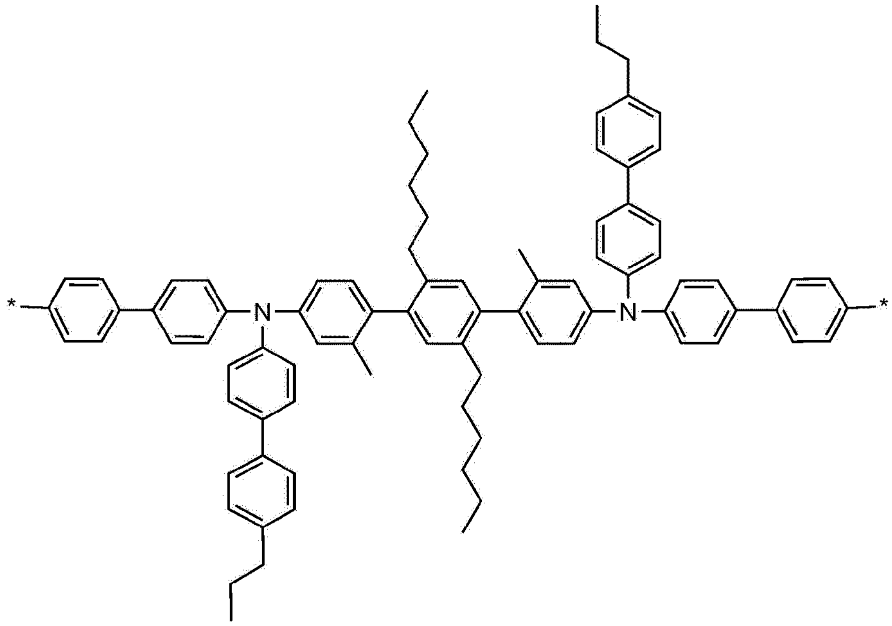

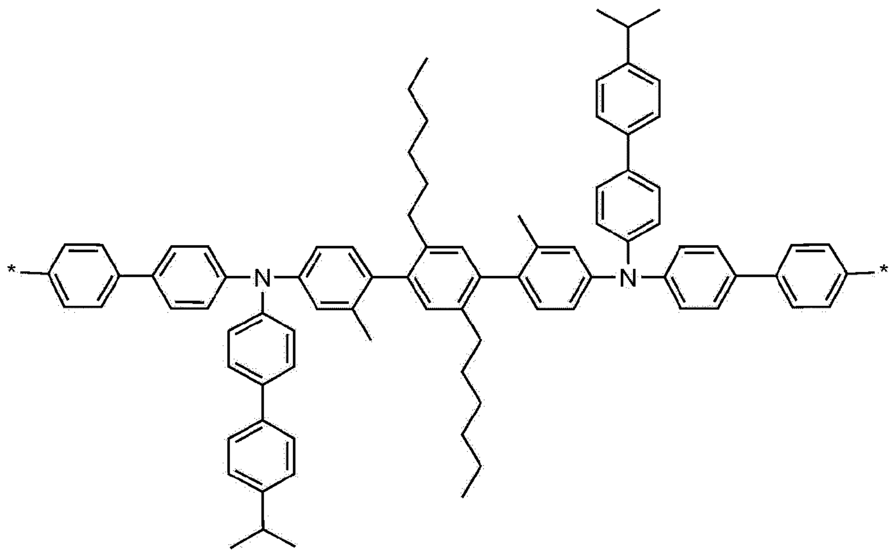

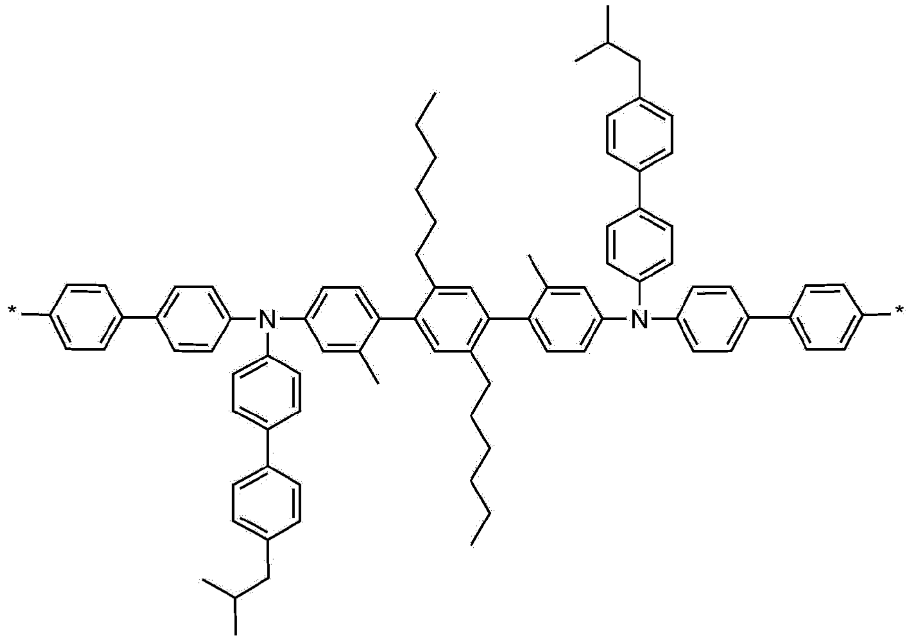

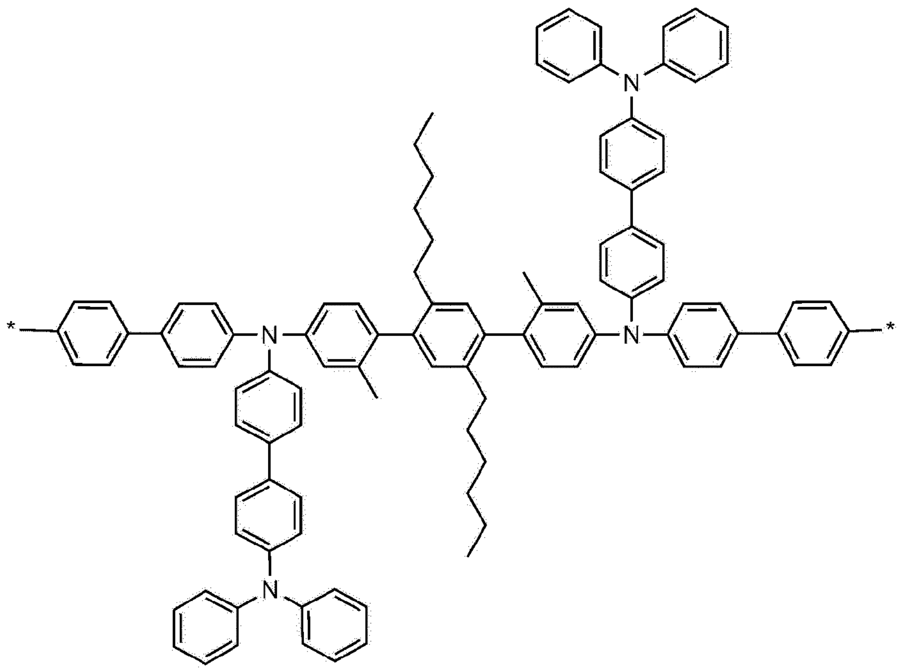

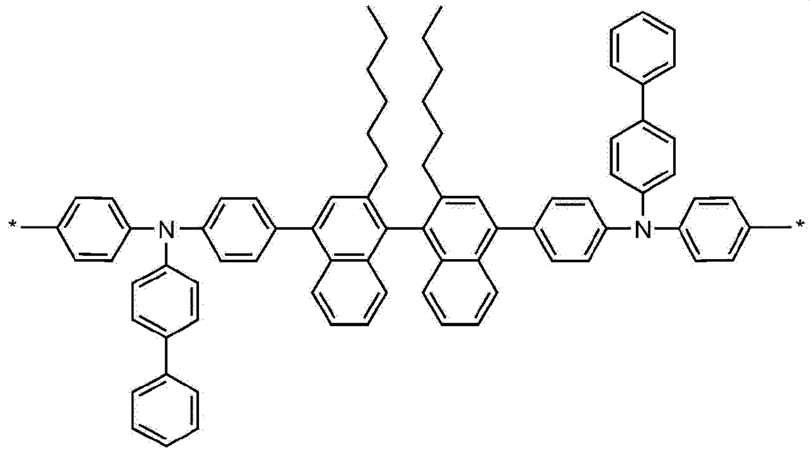

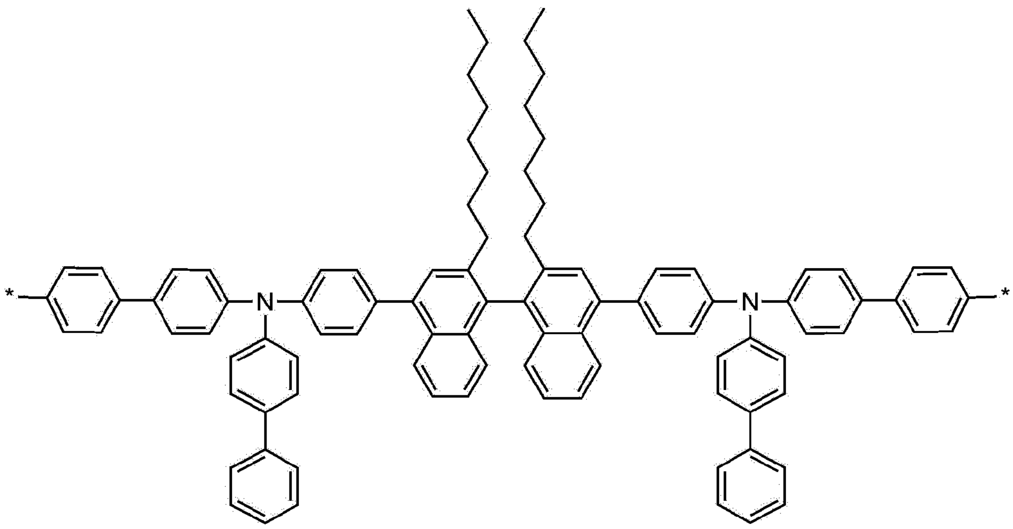

.

**10.** Organische lichtemittierende Vorrichtung gemäß Anspruch 1, worin:
jedes $R''_1$ unabhängig Wasserstoff, Fluor oder $CF_3$ ist.

**11.** Organische lichtemittierende Vorrichtung gemäß Anspruch 1, worin:
$Ar''_1$ irgendeines ist, das ausgewählt ist aus der Gruppe bestehend aus den Folgenden:

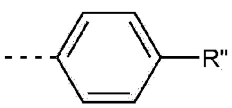 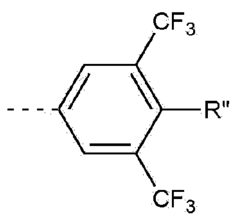 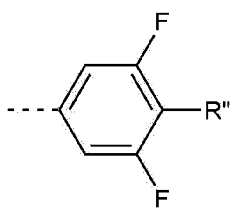 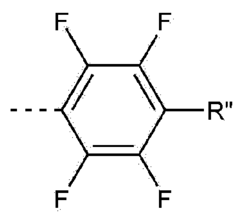

.

**12.** Organische lichtemittierende Vorrichtung gemäß Anspruch 1, worin:
jedes $R''_1$ unabhängig Wasserstoff, Fluor, $CF_3$, $CF(CF_3)_2$, $CF_2CF_2CF_2CF_3$, eine foto-härtbare Gruppe oder eine warmhärtende Gruppe ist.

**13.** Organische lichtemittierende Vorrichtung gemäß Anspruch 1, worin:
$Ar''_2$ irgendeines ist, das ausgewählt ist aus der Gruppe bestehend aus den Folgenden:

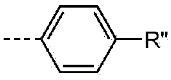
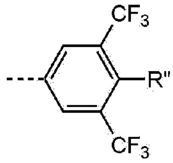
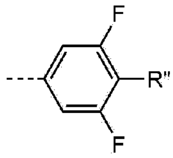
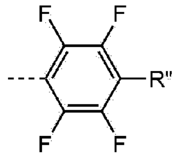

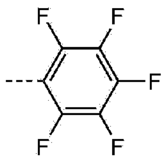
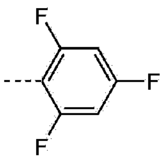
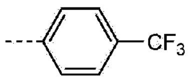
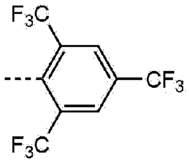

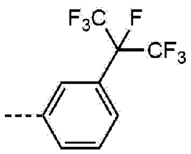
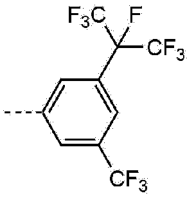
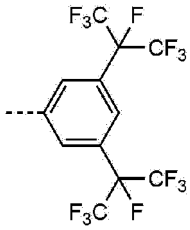
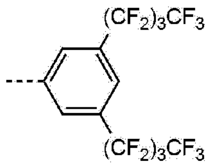

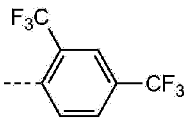
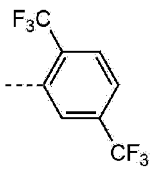
.

**14.** Organische lichtemittierende Vorrichtung gemäß Anspruch 1, worin: die durch die chemische Formel 2 dargestellte anionische Gruppe irgendeine ist, die ausgewählt ist aus der Gruppe bestehend aus den Folgenden:

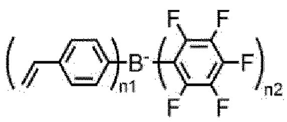
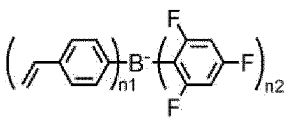
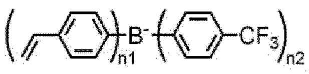

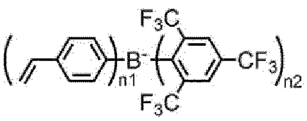
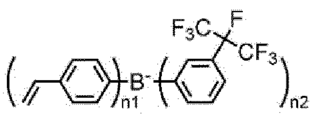
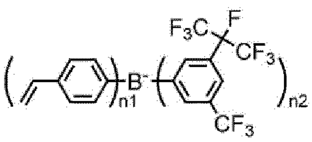

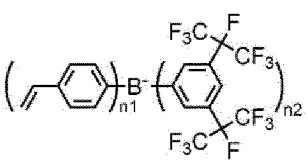
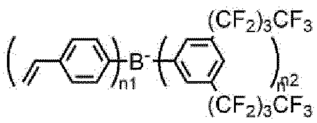
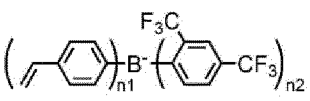

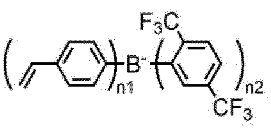
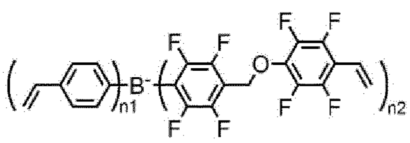
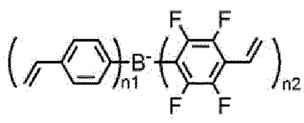

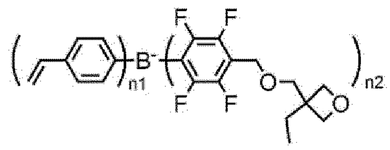

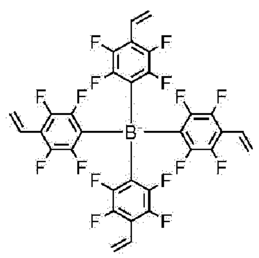

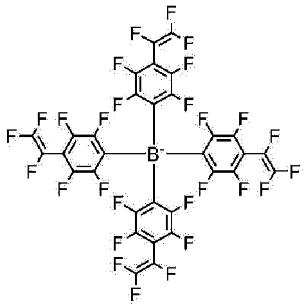

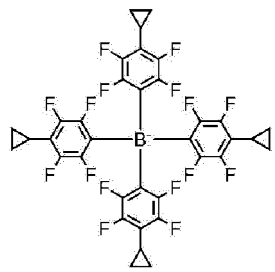

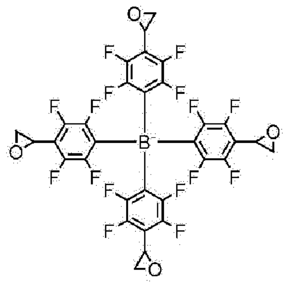

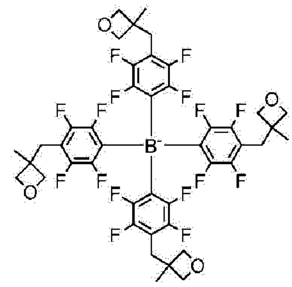

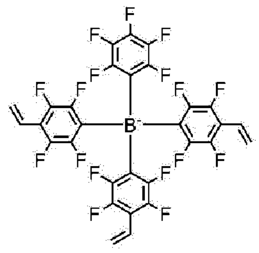

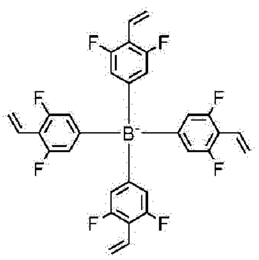

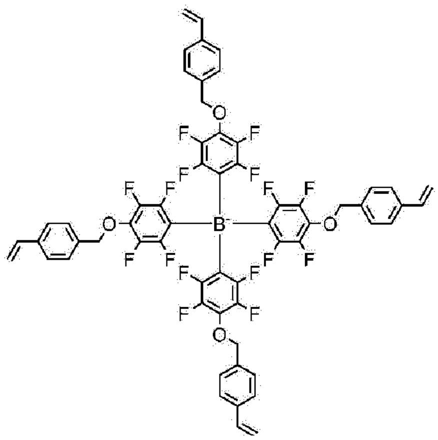

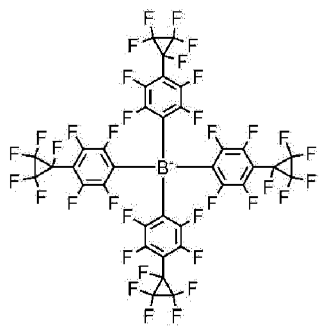

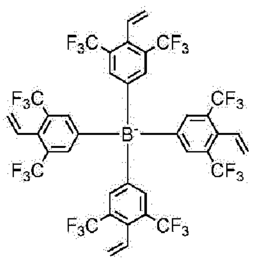

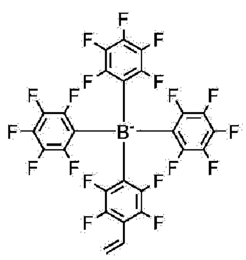

**15.** Organische lichtemittierende Vorrichtung gemäß Anspruch 1, worin: die anionische Verbindung eine kationische Gruppe enthält, und die kationische Gruppe ausgewählt ist aus einer monovalenten kationischen Gruppe, einer Oniumverbindung oder den folgenden Strukturformeln:

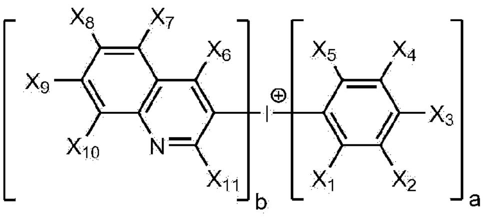 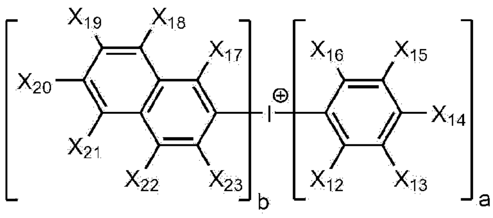

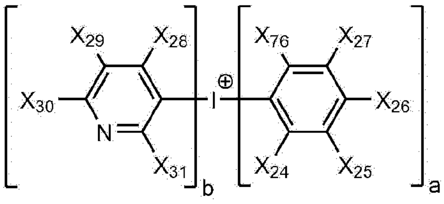 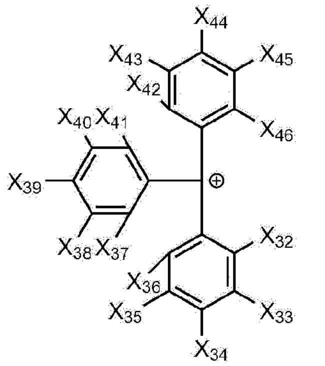 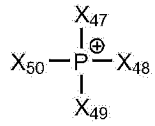

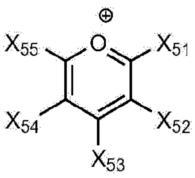 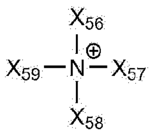 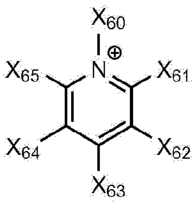 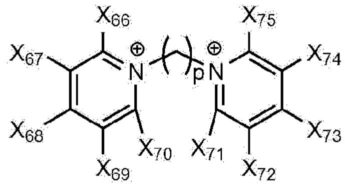 .

worin

$X_1$ bis $X_{76}$ jeweils unabhängig Wasserstoff, Cyano, Nitro, Halogen, $-COOR_{104}$, ein substituiertes oder unsubstituiertes $C_{1-60}$-Alkyl; ein substituiertes oder unsubstituiertes $C_{1-60}$-Alkoxy; ein substituiertes oder unsubstituiertes $C_{3-60}$-Cycloalkyl; ein substituiertes oder unsubstituiertes $C_{1-60}$-Fluoralkyl oder ein substituiertes oder unsubstituiertes $C_{6-60}$-Aryl, oder eine härtbare Gruppe ist,
$R_{104}$ Wasserstoff, Deuterium oder ein substituiertes oder unsubstituiertes $C_{1-60}$-Alkyl ist,
p eine ganze Zahl von 0 bis 10 ist,
a 1 oder 2 ist, b 0 oder 1 ist und a+b=2.

**16.** Organische lichtemittierende Vorrichtung gemäß Anspruch 15, worin:
die kationische Gruppe irgendeine ist, die ausgewählt ist aus der Gruppe bestehend aus den Folgenden:

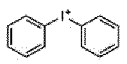 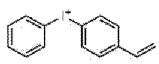 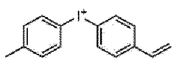 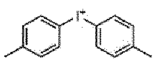 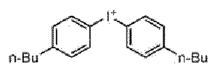

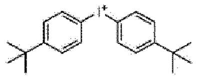 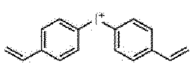 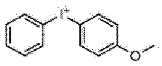 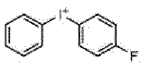 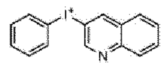

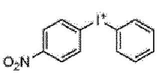 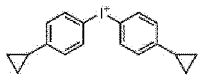 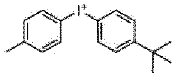 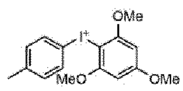 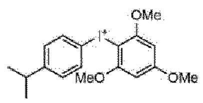

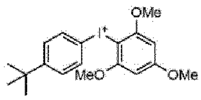
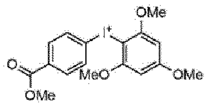
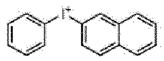
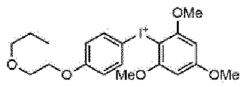
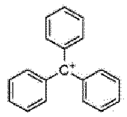

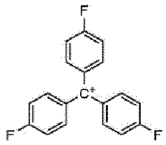
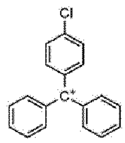
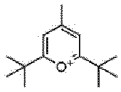
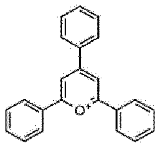
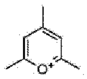

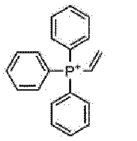
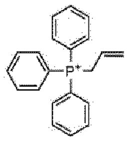
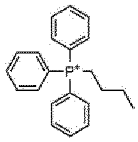
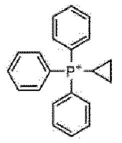
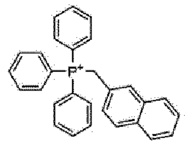

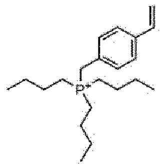
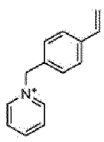
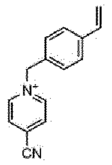
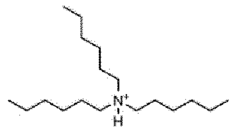
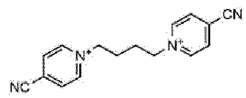
.

## Revendications

**1.** Dispositif électroluminescent organique comprenant :

une anode (2),
une cathode (5),
une couche électroluminescente (4) entre l'anode et la cathode, et
une couche de transport de trous (3) entre l'anode et la couche électroluminescente,
dans lequel ladite couche de transport de trous peut être une couche d'injection de trous, une couche de transport de trous, ou une couche qui injecte et transporte simultanément des trous ; et
dans lequel ladite couche de transport de trous comprend un polymère contenant une unité de répétition représentée par la Formule chimique 1 suivante, et un composé ionique contenant un groupe anionique représenté par la Formule chimique 2 :

[Formule chimique 1]

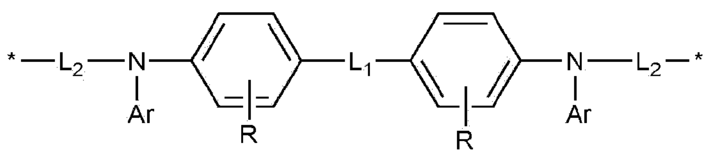

dans lequel dans la Formule chimique 1,

$L_1$ est un arylène en $C_{6-60}$ substitué ou non substitué,
chaque $L_2$ est indépendamment un arylène en $C_{6-60}$ substitué ou non substitué,
chaque Ar est indépendamment un aryle en $C_{6-60}$ substitué ou non substitué,
chaque R est indépendamment un hydrogène, un deutérium, ou un alkyle en $C_{1-10}$ substitué ou non substitué,

[Formule chimique 2]

$$(Ar''_1)_{n1}-B^{\ominus}-(Ar''_2)_{n2}$$

dans lequel dans la Formule chimique 2,

n1 et n2 sont chacun indépendamment un nombre entier de 1 à 3, à la condition que n1 + n2 soit 4, $Ar''_1$ est

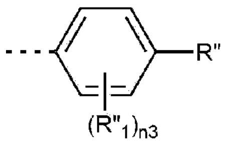

R" est un groupe photodurcissable ; ou un groupe thermodurcissable,
chaque $R''_1$ est indépendamment un hydrogène, un halogène, ou un haloalkyle en $C_{1-60}$,
n3 est un nombre entier de 1 à 4,

$Ar''_2$ est

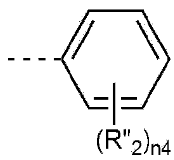

chaque $R''_2$ est indépendamment un hydrogène, un halogène, un haloalkyle en $C_{1-60}$, un groupe photodurcissable, ou un groupe thermodurcissable, et
n4 est un nombre entier de 1 à 5 ;

dans lequel le polymère comprend en outre une unité de répétition choisie sélectionnée parmi le groupe consistant en les composés suivants :

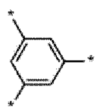 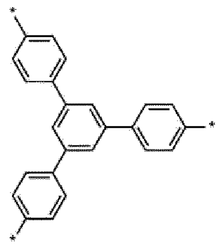 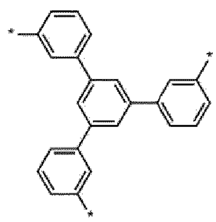 .

**2.** Dispositif électroluminescent organique selon la revendication 1, dans lequel :
$L_1$ est le phénylène, le biphényldiyle, ou le binaphthyldiyle, et
le $L_1$ est non substitué ou substitué avec un ou deux alkyles en $C_{1-10}$, ou un ou plusieurs deutériums.

**3.** Dispositif électroluminescent organique selon la revendication 1, dans lequel :
$L_1$ est représenté par l'un quelconque des composés suivants :

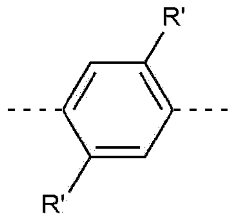 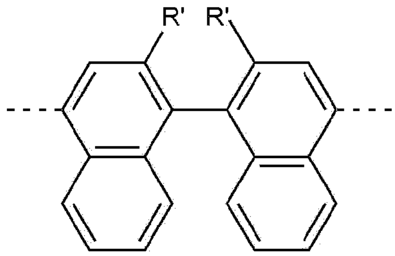

dans lequel,
chaque R' est indépendamment un alkyle en $C_{1-10}$.

**4.** Dispositif électroluminescent organique selon la revendication 3, dans lequel : chaque R' est indépendamment un méthyle, un propyle, un butyle, un pentyle, ou un hexyle.

**5.** Dispositif électroluminescent organique selon la revendication 1, dans lequel :
chaque $L_2$ est indépendamment le phénylène, ou le biphényldiyle, et
le $L_2$ est non substitué ou substitué avec un ou plusieurs deutériums.

**6.** Dispositif électroluminescent organique selon la revendication 1, dans lequel :
chaque Ar est indépendamment un phényle, ou un biphénylyle, et
l'Ar est non substitué ou substitué avec un alkyle en $C_{1-10}$, un N(aryle en $C_{6-60})_2$, ou un ou plusieurs deutériums.

**7.** Dispositif électroluminescent organique selon la revendication 1, dans lequel :
Ar est le biphénylyle, et
l'Ar est non substitué ou substitué avec un propyle, un isopropyle, un butyle, un isobutyle, un N(phényle)$_2$, ou un ou plusieurs deutériums.

**8.** Dispositif électroluminescent organique selon la revendication 1, dans lequel : chaque R est indépendamment un hydrogène, un deutérium, ou un méthyle.

**9.** Dispositif électroluminescent organique selon la revendication 1, dans lequel : la Formule chimique 1 est représentée par un quelconque sélectionné parmi le groupe consistant en les composés suivants :

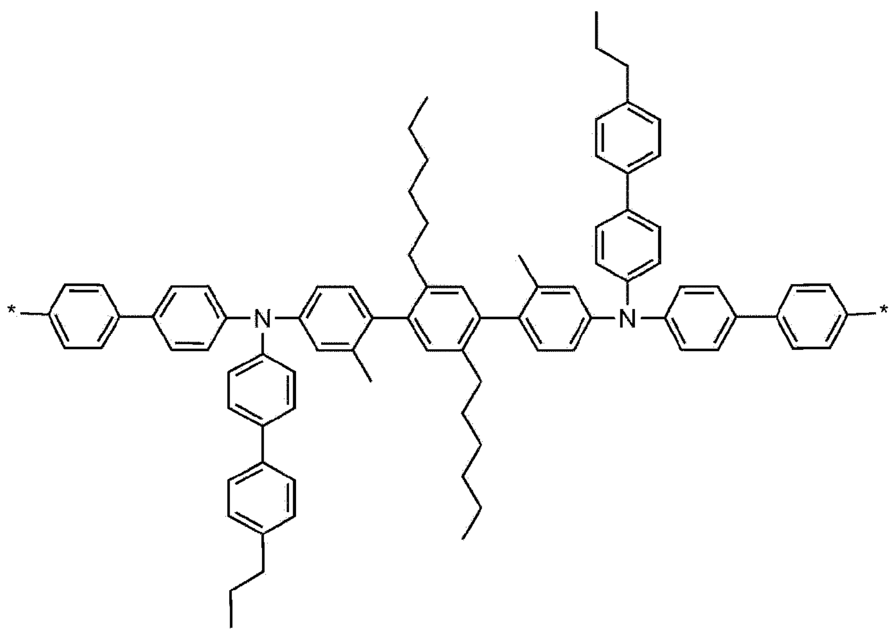

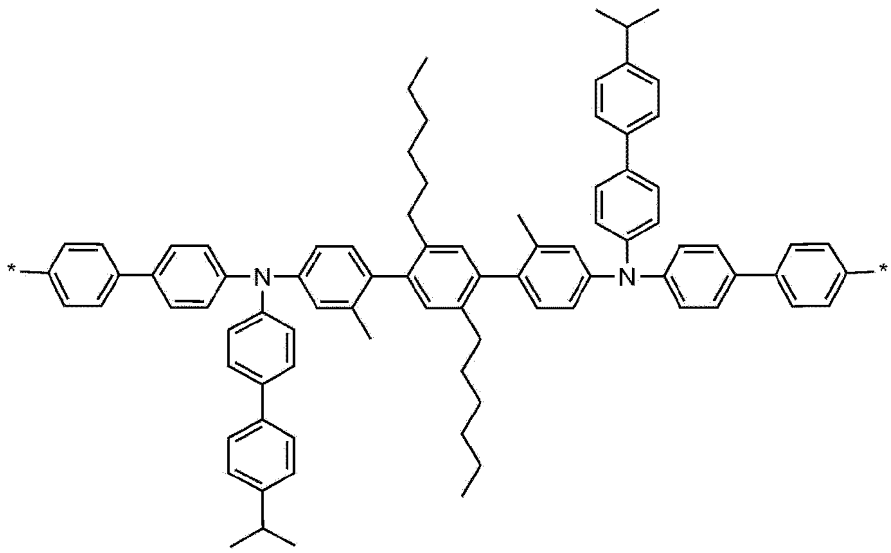

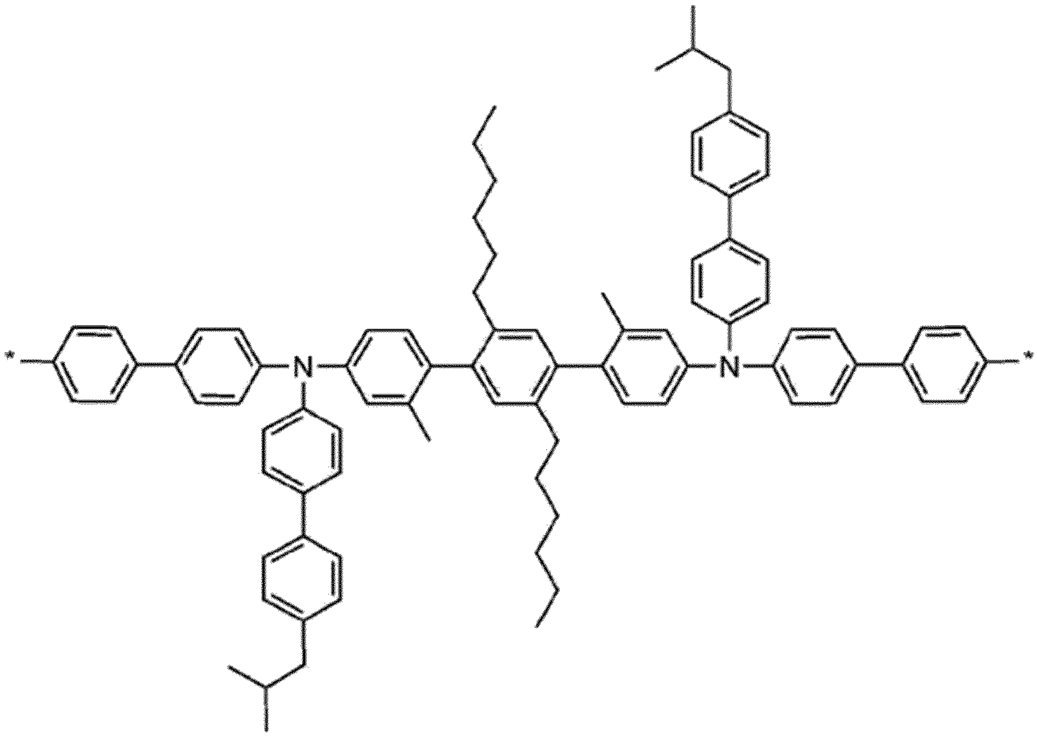

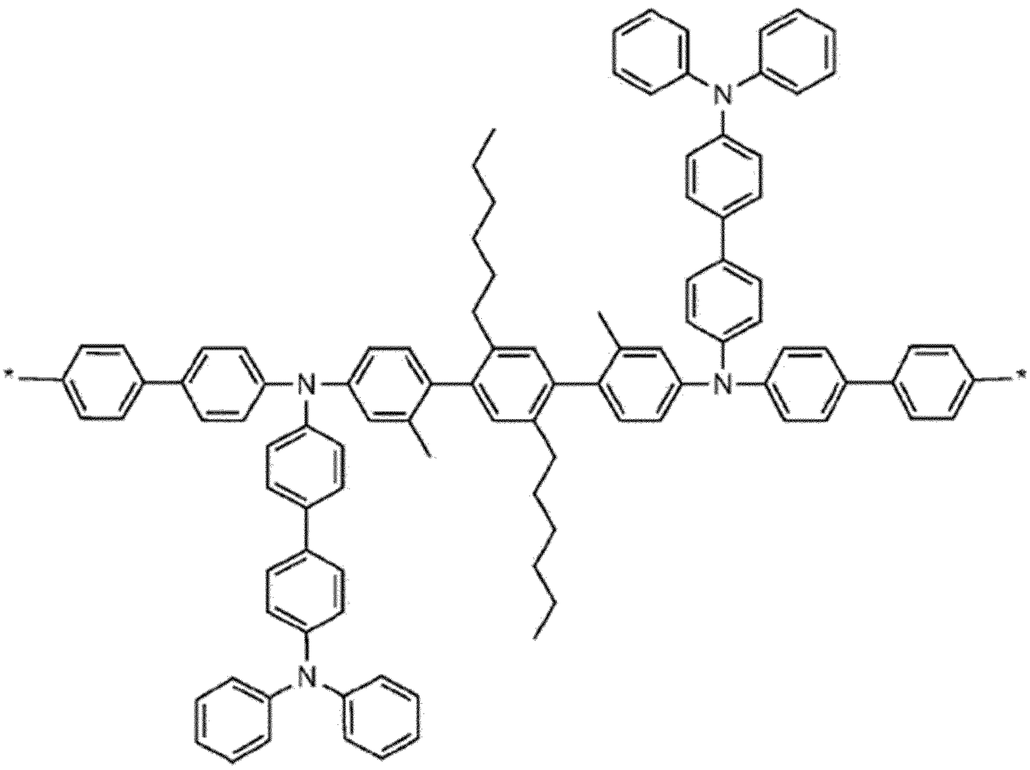

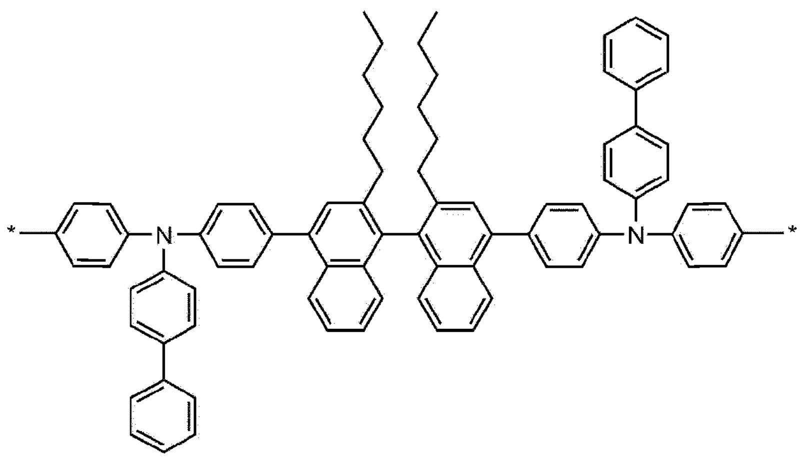

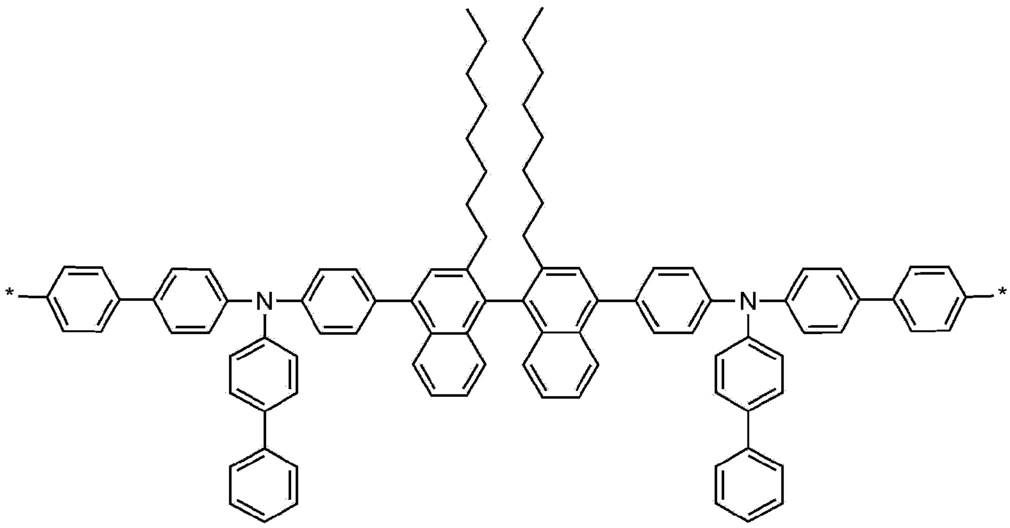

10. Dispositif électroluminescent organique selon la revendication 1, dans lequel : chaque R"$_1$ est indépendamment un hydrogène, un fluoro, ou $CF_3$.

11. Dispositif électroluminescent organique selon la revendication 1, dans lequel : Ar"$_1$ est un quelconque sélectionné parmi le groupe consistant en les composés suivants :

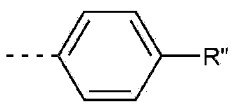 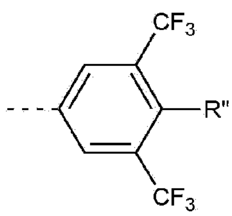 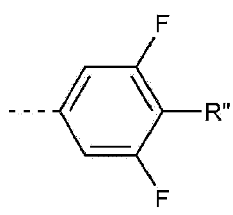 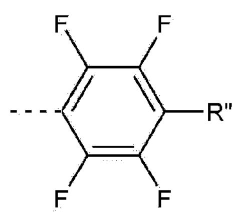

12. Dispositif électroluminescent organique selon la revendication 1, dans lequel : chaque R"$_1$ est indépendamment un hydrogène, un fluoro, $CF_3$, $CF(CF_3)_2$, $CF_2CF_2CF_2CF_3$, un groupe photodurcissable, ou un groupe thermodurcissable.

13. Dispositif électroluminescent organique selon la revendication 1, dans lequel : Ar"$_2$ est un quelconque sélectionné parmi le groupe consistant en les composés suivants :

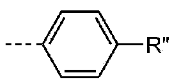 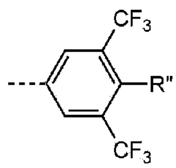 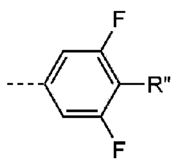 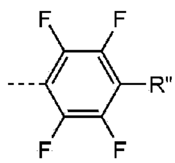

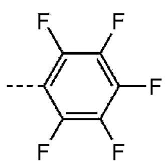 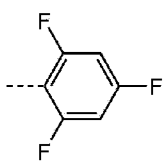 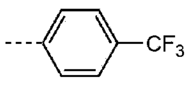 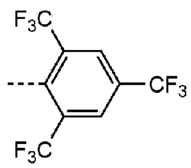

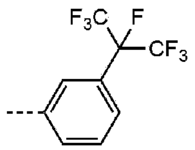 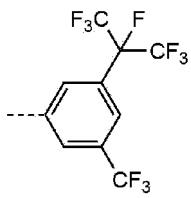 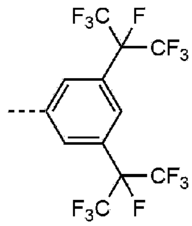 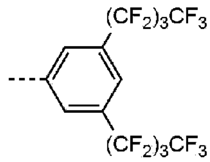

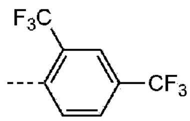 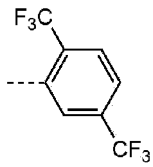

**14.** Dispositif électroluminescent organique selon la revendication 1, dans lequel : le groupe anionique représenté par la Formule chimique 2 est un quelconque sélectionné parmi le groupe consistant en les composés suivants :

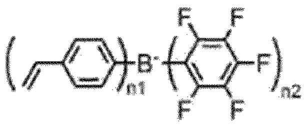 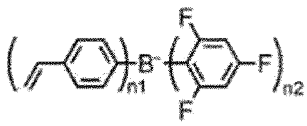 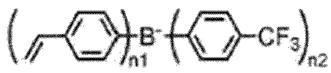

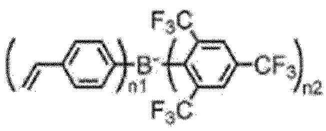 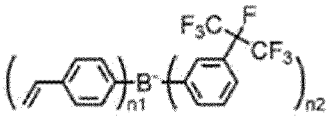 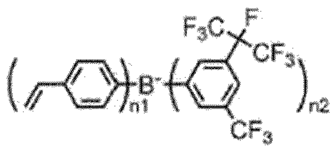

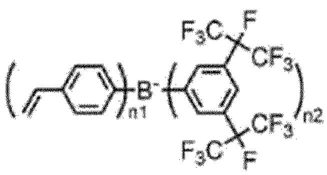 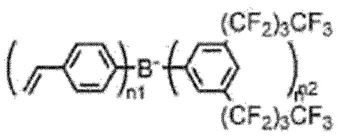 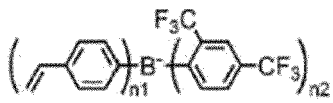

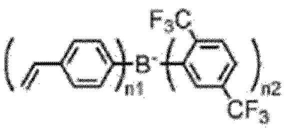 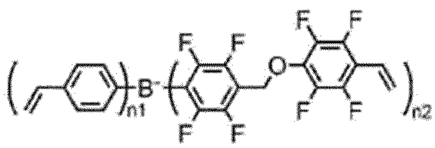 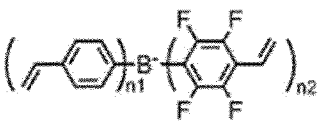

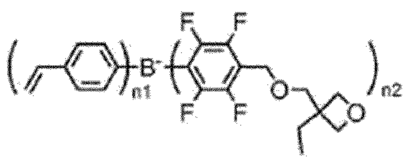

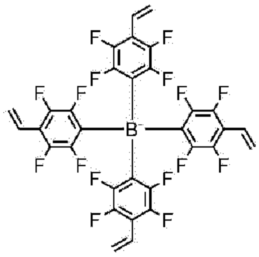
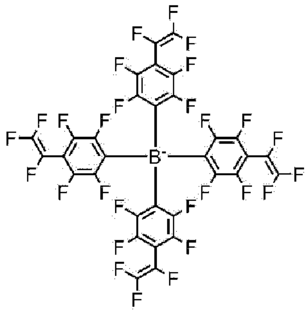
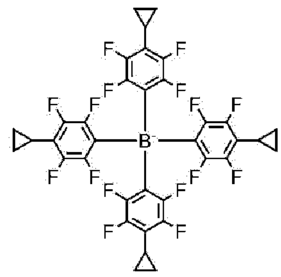
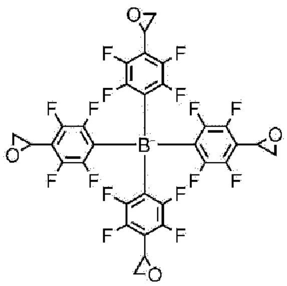
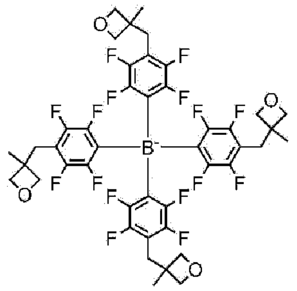
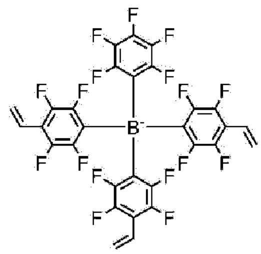
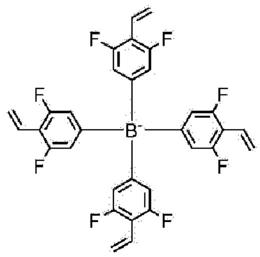
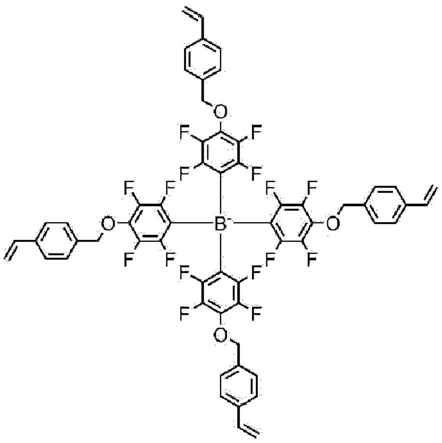
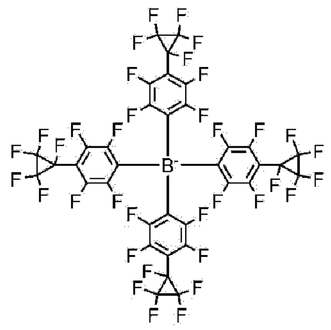
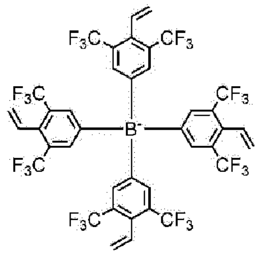
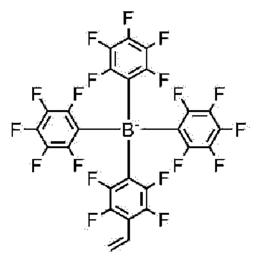

**15.** Dispositif électroluminescent organique selon la revendication 1, dans lequel : le composé anionique contient un groupe cationique, et le groupe cationique est sélectionné parmi un groupe cationique monovalent, un composé onium ou les formulas structurelles suivantes :

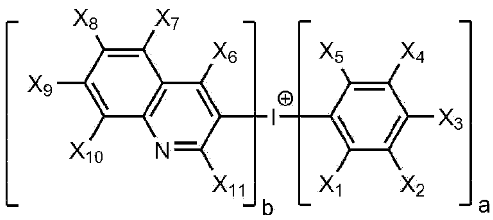
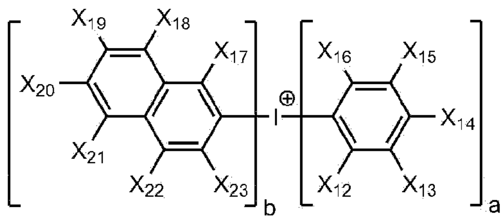

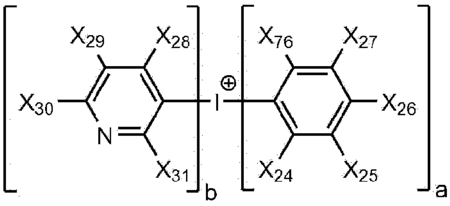
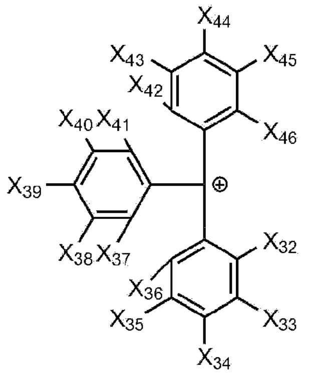
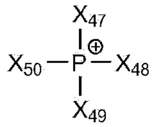

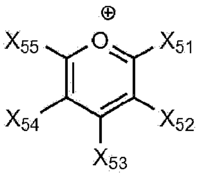
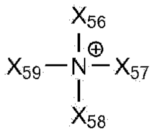
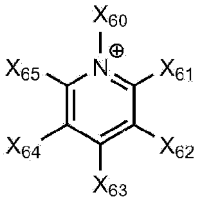
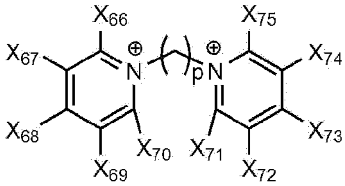

dans lequel,

$X_1$ à $X_{76}$ sont chacun indépendamment un hydrogène ; un cyano ; un nitro ; un halogène ; -$COOR_{104}$ ; un alkyle en $C_{1-60}$ substitué ou non substitué ; un alcoxy en $C_{1-60}$ substitué ou non substitué ; un cycloalcoxy en $C_{3-60}$ substitué ou non substitué ; un fluoroalkyle en $C_{1-60}$ substitué ou non substitué ; ou un aryle en $C_{6-60}$ substitué ou non substitué ; ou un groupe durcissable,
$R_{104}$ est un hydrogène ; un deutérium ; ou un alkyle en $C_{1-60}$ substitué ou non substitué,
p est un nombre entier de 0 à 10,
a est 1 ou 2, b est 0 ou 1, et a + b = 2.

**16.** Dispositif électroluminescent organique selon la revendication 15, dans lequel :
le groupe cationique est un quelconque sélectionné parmi le groupe consistant en les composés suivants :

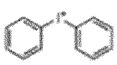
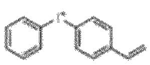
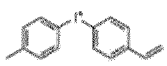
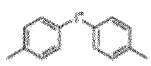
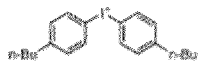

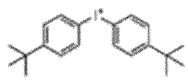
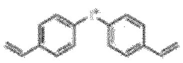
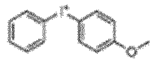
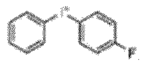
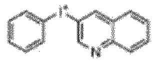

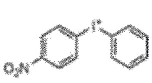
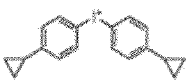
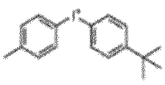
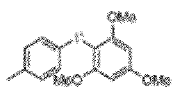
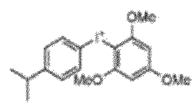

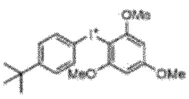
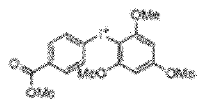
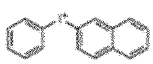
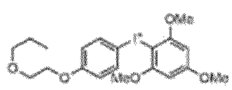
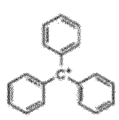

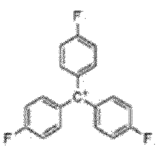
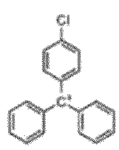
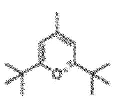
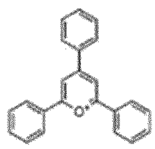
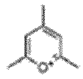

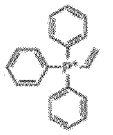
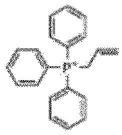
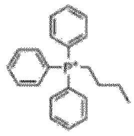
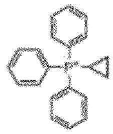
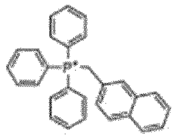

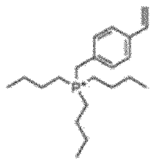
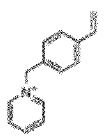
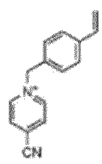
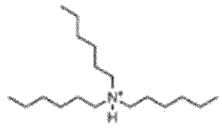
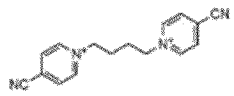

[FIG. 1]

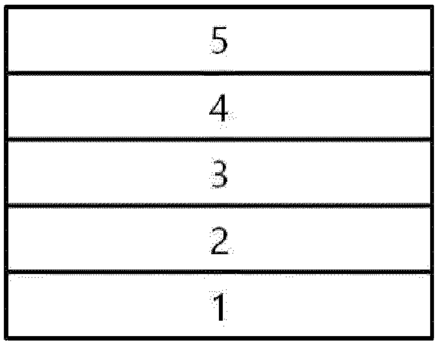


[FIG. 2]

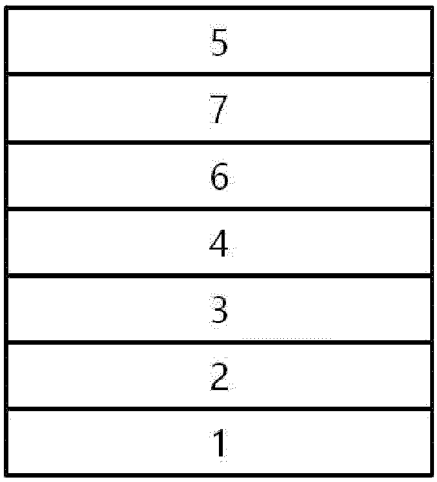

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020200098674
- KR 1020210098389
- WO 2020111603 A1
- WO 2019066338 A1
- WO 2011159876 A2
- KR 1020000051826
- WO 2003012890 A